# EUROPEAN PATENT APPLICATION

(11) **EP 1 860 376 A1**
(43) Date of publication of application: **28.11.2007**
(21) Application number: 06016850.7
(22) Date of filing: 11.08.2006
(51) Int. Cl.: F21V 9/16, H01J 61/42, H01J 61/35, H01J 1/70

(54) **Brightness enhancement structure of luminescent assembly**

(30) Priority: 27.05.2006 EP 06010909
(71) Applicant: Mii, Jenn-Wei, Da-an District, Taipei City 106 (TW)
(72) Inventor: Mii, Jenn-Wei, Da-an District, Taipei City 106 (TW)
(74) Representative: Negendanck, Matthias

(57) **Abstract**

The present invention relates to a brightness-enhanced light-emitting structure of a luminescent assembly, and more particularly, to a structure capable of enhancing the brightness of a luminescent assembly by directing blue/ultraviolet light of a light-emitting source (10) to shine on a fluorescent/phosphorescent coating so as to excite visible light therefrom in a surface excitation manner. The brightness-enhanced light-emitting structure of a luminescent assembly is comprised of: a blue/ultraviolet light-emitting source (10) having a side thereof being coated with a cover layer (11); and a light screen (20) disposed outside the light-emitting source (10), having a primary visible light layer (21) arranged on the inner surface there of at a position opposite to the cover-layer-coated side of the light source (10); wherein a visible light or white light, being a mixture of visible lights, is emitted from the primary visible light layer (21) in the surface excitation manner as soon as the primary visible light layer (21) is irradiated by the ultraviolet or blue light of the light- emitting source (10), while the cover layer (11) of the light-emitting source (10) is blocking the harmful ultraviolet light and the same time being excited directly or indirectly to generate another visible light, and thus the brightness of the luminescent assembly is enhanced.

## Description

### FIELD OF THE INVENTION

The present invention relates to a brightness-enhanced light-emitting structure of a luminescent assembly, and more particularly, to a structure capable of enhancing the brightness of a luminescent assembly by directing blue/ultraviolet light of a light-emitting source to shine on a fluorescent/phosphorescent coating so as to excite visible light therefrom in a surface excitation manner.

### BACKGROUND OF THE INVENTION

Generally, the brightness of any conventional luminescent apparatus, such as a fluorescent lamp, is dependent upon the luminous intensity of the light source used thereby. As fluorescent lamps are more efficient than incandescent light bulbs of an equivalent brightness since more of the consumed energy is converted to usable light and less is converted to heat, allowing fluorescent lamps to run cooler, most luminescent apparatuses available now adopt fluorescent lamps as their light sources. A fluorescent lamp is substantially a glass tube filled with an inert gas and mercury vapor while the inner surface of the tube is coated with a fluorescent paint made of varying blends of phosphors. When the light is turned on, the electric power heats up the cathode of the fluorescent lamp enough for it to emit electrons. These electrons collide with and ionize inert gas atoms in the tube to form a plasma by a process of impact ionization. As a result of avalanche ionization, the conductivity of the ionized gas rapidly rises, allowing higher currents to flow through the lamp, and thus the mercury is then likewise ionized, causing it to emit light in the ultraviolet (UV) region. The UV light is absorbed by the fluorescent coating, which re-radiates the energy at lower frequencies to emit visible light. The blend of phosphors controls the color of the light, and along with the tube's glass prevents the harmful UV light from escaping. However, the aforesaid fluroscent lamp is disadvantageous in that:
(1) As the fluorescent coating is a phosphor film with a specific thickness while the surface of the phosphor film can be easily excited by the ultraviolet light to emit visible light, the intensity of the ultraviolet light is weakening as it is penetrating deeper into the phosphor film so that the visible light generated deep in the phosphor is conceivably fewer than that from the surface of the fluorescent coating. Consequently, the fluorescent coating can be considered to be a light emitting device capable of emitting most light from its surface and lesser light from its interior. That is, visible light created deep inside the fluorescent coating will be weaker than that created at the surface thereof.
(2) The fluorescent coating is not a good translucent material and will cause the luminous intensity of the visible light, generated from the surface thereof, to be weakened when it is passing through the fluorescent coating and exiting from the glass tube. That is, the luminous intensity of the visible light is adversely affected by the fluorescent coating.

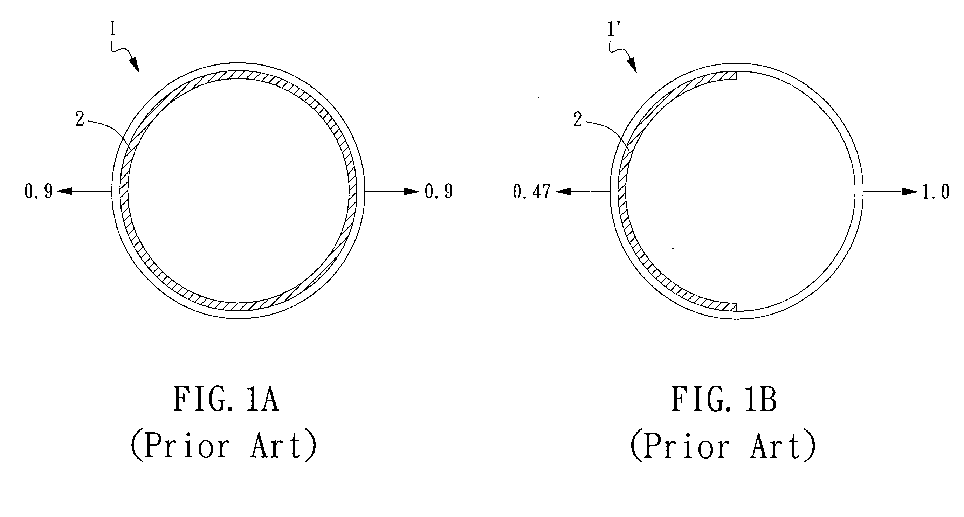

As a conventional fluorescent lamp 1, shown in FIG. 1A, is a sealed glass tube containing a fluorescent coating 2 coated along the inside of the glass, most of the visible light generated form the inner surface of the fluorescent coating 2 is blocked by the fluorescent coating 2 itself that causes the brightness inside the tube is actually better than that outside the tube, That is, the brightness of the fluorescent lamp 1 is mainly dependent upon those visible light generated from the interior of the fluorescent coating 2 so that the conventional fluorescent lamp is most likely to have poor brightness. In addition, as the visible light, generated form the inner surface of the fluorescent coating 2, passes through the filtering of the fluorescent coating 2 and reaches the glass tube, the remaining visible light is once again being filtered by the glass tube and weakened again. Therefore, the luminous efficacy of most conventional fluorescent lamps is poor since they are suffered from the visible light being filtered by fluorescent coating, as addressed in the description hereinbefore.

Moreover, if only half of the inner surface of the glass tube of a fluorescent lamp 1' is coated by the fluorescent coating 2 while another half of the glass tube is considered to be transparent, as shown in FIG. 1B, the visible light, generated form the surface of the fluorescent coating 2 can be discharged out of the fluorescent lamp 1' directly through the transparent half of the glass tube without being filtered by the fluorescent coating 2, and thus the aforesaid problem of poor brightness caused by the filtering of the fluorescent coating 2 can be avoided. However, as the ultraviolet light can also being discharged directly out of the fluorescent lamp 1' through the transparent half of the glass tube without being filtered by the fluorescent coating 2, it can cause damages to eyes and skins in spite of most of the ultraviolet light is filtered out by the glass tube. Therefore, the forgoing half-coated fluorescent lamp 1' is not recommended. Apart from the aforesaid reasoning of not recommending, the portion of the ultraviolet light, being directly discharged out of the fluorescent lamp 1' without hitting on the fluorescent coating 2, is wasted since it is not used for exciting usable visible light. Therefore, it is conceivable that the brightness of the half-coated fluorescent lamp 1' can be greatly improve if the portion of the wasted ultraviolet light can be salvaged and made good use of.

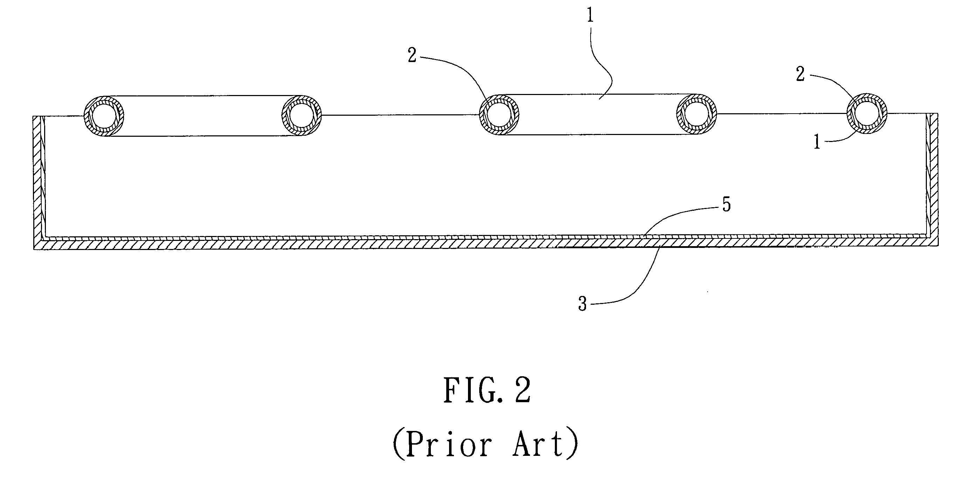

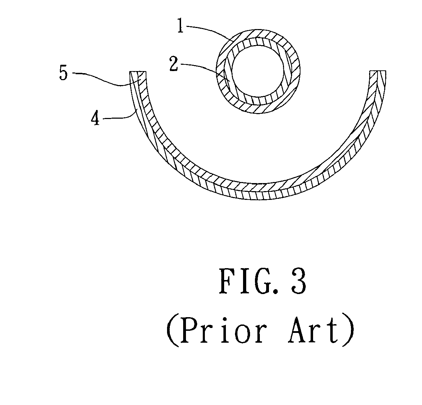

Referring to FIG. 1A and FIG. 1B and quantifying the brightness of the visible light generated from the surface of the fluorescent coating 2 to be 1.0 unit, illustrated in FIG. 1B, the brightness measured from the outside of the fluorescent lamp 1, that is, the totality of the visible light generated from the interior of the fluorescent coating 2 and those remaining visible light generated form the inner surface of the fluorescent coating 2 and filtered by the fluorescent coating 2, is about 0.9 unit, while the brightness measured from the outside the coated-half of the fluorescent lamp 1' is only 0.47 unit since it is suffered from the aforesaid waste of ultraviolet light. Hence, although most conventional luminescent assemblies, employing the fluorescent lamp 1 of FIG. 1A as its light source, such as the box-like luminescent assembly 3 having a plurality of fluorescent lamps 1 arranged at the opening thereof, as shown in FIG. 2, or an arc-shaped luminescent assembly 4 having a fluorescent lamp 1 arranged at the concave of the same, as shown in FIG. 3, all have reflection sheet 5 configured therein for increasing the brightness thereof, all those conventional luminescent assemblies still have poor brightness since the luminous efficacy of the light source employed thereby, i.e. the fluorescent lamps 1, is poor.

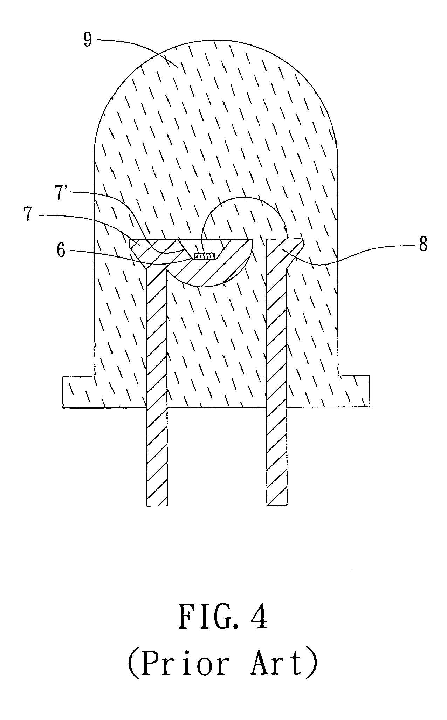

A conventional lamp-type white LED is configured, for example, as shown in FIG. 4. That is, in FIG. 4, a white LED includes a pair of lead frames 7 and 8, and a blue LED chip 6 mounted on top of a cup-like base 7' formed on the upper end surface of the lead frame 7, wherein the blue chip 6 is boned to the lead frame 8 by a bonding wire and protected with and package by a fluorescent resin envelop 9, made of a mixture of a filling material and a phosphor capable of emitting a wide range of lights centering around yellow light. Moreover, a light reflecting layer is formed on the inner surface of the cup-like base 7' while surrounding the blue LED chip 6, by which as blue light from the blue LED chip 6 is reflected by the light reflecting layer of the cup-like base 7' and shine on the fluorescent resin envelop 9, the phosphor doped in the fluorescent resin envelop 9 is excited, producing yellow light and externally emitting white light as a result of mixing of the two lights.

Although the aforesaid LED can be considered as a surface-emitting LED, the luminous efficacy is poor since the blue chip 6 is fixedly arranged at the bottom of the cup-like base 7' and the brightness yellow light is excited at the top surface of the LED chip 6 contacting the fluorescent resin envelop 9, so that the brightness of the excited yellow light is decreasing as it is traveling in the fluorescent resin envelop 9 before emitting.

### SUMMARY OF THE INVENTION

In view of the disadvantages of prior art of poor brightness, the primary object of the present invention is to provide a structure capable of enhancing the brightness of a luminescent assembly by directing blue/ultraviolet light of a light-emitting source to shine on a fluorescent/phosphorescent coating so as to excite visible light therefrom in a surface excitation manner.

To achieve the above object, the invention provide a brightness-enhanced light-emitting structure of a luminescent assembly, comprising:
a light-emitting source, capable of emitting blue/ultraviolet light, having a cover layer formed on a side of the circumference thereof while enabling the cover layer to be composed of a light reflecting layer; and
a light screen, disposed surrounding the light-emitting source, having a primary visible light layer formed at a portion of the inner surface of the light screen at the position corresponding to the side of the light-emitting source where is not covered by the cover layer;
wherein, the primary visible light layer is mainly composed of a fluorescent/phosphorescent coating; and a visible light is emitted from the primary visible light layer in the surface excitation manner as soon as the primary visible light layer is irradiated by the ultraviolet or blue light of the light-emitting source, while the cover layer of the light-emitting source is blocking the harmful ultraviolet light and the same time being excited directly or indirectly to generate another visible light, and thus the brightness of the luminescent assembly is enhanced.

Other aspects and advantages of the present invention will become apparent from the following detailed description, taken in conjunction with the accompanying drawings, illustrating by way of example the principles of the present invention.

### BRIEF DESCRIPTION OF THE DRAWINGS

FIG. 1A and FIG. 1B are schematic diagrams showing the brightness of two conventional fluorescent lamps.

FIG. 2 is a cross sectional view of a box-like luminescent assembly having a plurality of conventional fluorescent lamps arranged at the opening thereof.

FIG. 3 is a cross sectional view of an arc-shaped luminescent assembly having a conventional fluorescent lamp arranged at the concave of the same.

FIG. 4 shows a conventional artillery-shell-shaped light emitting diode.

FIG. 5 is a schematic diagram showing a luminescent assembly according to a first embodiment of the invention.

FIG. 6 is a perspective view illustrating a cross section of a brightness-enhanced light-emitting structure used in the luminescent assembly of the first embodiment of the invention, whereas the cover layer is coated on the inner circumference of the light-emitting source thereof.

FIG. 7 is a cross sectional view of the brightness-enhanced light-emitting structure of FIG. 6

FIG. 7A is a cross sectional view of the brightness-enhanced light-emitting structure of FIG. 5 having an addition light reflecting layer with a plurality of holes formed on the cover layer thereof.

FIG. 8 is a cross sectional view of the brightness-enhanced light-emitting structure of FIG. 6 having an additional light reflecting layer sandwiched between the primary visible light layer and the inner circumference of the light screen.

FIG. 9 is a cross sectional view of the brightness-enhanced light-emitting structure of FIG. 6, whereas the cross section of the light-emitting source is in a shape of a semi-circular.

FIG. 10 is a cross sectional view of the brightness-enhanced light-emitting structure of FIG. 6, whereas the cross section of the light-emitting source is in a shape of a triangle.

FIG. 11 is a cross sectional view of the brightness-enhanced light-emitting structure of FIG. 6, whereas the cross section of the light-emitting source is in a shape of a square.

FIG. 12 is a cross section of another brightness-enhanced light-emitting structure used in the luminescent assembly of the first embodiment of the invention, whereas the cover layer is coated on the outer circumference of the light-emitting source thereof.

FIG. 12A is a cross section of the brightness-enhanced light-emitting structure of FIG. 12 having an additional light reflecting layer sandwiched between the cover layer and the outer circumference of the light-emitting source.

FIG. 13 shows an appearance of the luminescent assembly of FIG. 5.

FIG. 14 shows another appearance of the luminescent assembly of FIG. 5.

FIG. 15 shows yet another appearance of the luminescent assembly of FIG. 5.

FIG. 16 shows further another appearance of the luminescent assembly of FIG. 5.

FIG. 17 shows one another appearance of the luminescent assembly of FIG. 5.

FIG. 18 is a schematic diagram showing a brightness-enhanced light-emitting structure of a luminescent assembly according to a second embodiment of the invention, whereas the light-emitting source can be in any shape while being received in a box-like light screen, and the cover layer is coated on the inner circumference of the light-emitting source thereof.

FIG. 19 is a schematic diagram showing another brightness-enhanced light-emitting structure of FIG. 18, whereas the cover layer is coated on the outer circumference of the light-emitting source thereof.

FIG. 20A to FIG. 20D are cross-sectional views of the four different shaped light screens, being used in the luminescent assembly of FIG. 18.

FIG. 21 is a cross sectional view of yet another brightness-enhanced light-emitting structure of FIG. 18.

FIG. 22 is a cross sectional view of a brightness-enhanced light-emitting structure of a luminescent assembly according to a third embodiment of the invention, whereas the light screen is a solid semi-circular base and the cross section of the light-emitting source thereof is in a shape of a square.

FIG. 23 is a cross sectional view of another brightness-enhanced light-emitting structure of FIG. 22, whereas the cross section of the light-emitting source thereof is in a shape of a semi-circular.

FIG. 24 is a cross sectional view of yet another brightness-enhanced light-emitting structure of FIG. 22, whereas the cross section of the light-emitting source thereof is in a shape of a triangle.

FIG. 25 is a cross sectional view of further another brightness-enhanced light-emitting structure of FIG. 22, whereas the cross section of the light-emitting source thereof is in a shape of a circle.

FIG. 26 is a cross sectional view of the brightness-enhanced light-emitting structure of FIG. 22, whereas the light reflecting layer of FIG. 22 is replaced by a transparent cover, partially coated with fluorescent coating while another portion being covered by a reflection layer.

FIG. 27 is a cross sectional view of another brightness-enhanced light-emitting structure of FIG. 22, whereas the light screen of solid base is replaced by a hollow base.

FIG. 28 is a perspective view of a light-emitting source of a brightness-enhanced light-emitting structure according to a fourth embodiment of the invention.

FIG. 29 is a perspective view of another brightness-enhanced light-emitting structure of FIG. 28.

FIG. 30 is a perspective view of yet another brightness-enhanced light-emitting structure of FIG. 28.

FIG. 31 is a schematic view of a brightness-enhanced light-emitting structure according to a fifth embodiment of the invention.

FIG. 32 is a schematic view of another brightness-enhanced light-emitting structure of FIG. 31, whereas the structure further has an additional insulating layer sandwiched between the light-emitting sources and the sealing cap.

FIG. 33 is a schematic view of yet another brightness-enhanced light-emitting structure of FIG. 31, whereas the cover layer is formed directly on top of the light-emitting sources.

FIG. 34 is a schematic diagram showing a brightness-enhanced light-emitting structure of the invention, being used as the backlight module of a liquid crystal display.

FIG. 35 is a schematic diagram showing a luminescent assembly according to a sixth embodiment of the invention.

FIG. 36 is a cross sectional view of a luminescent assembly according to a seventh embodiment of the invention.

FIG. 37 is a bottom view of the light-emitting source of FIG. 36.

FIG. 38 is a cross sectional view of a luminescent assembly according to an eighth embodiment of the invention.

FIG. 39 is a perspective view of the luminescent assembly of FIG. 38.

FIG. 40 is a cross sectional view of another brightness-enhanced light-emitting structure of FIG. 35, whereas the cross section of the light screen thereof is in a shape of a semi-circular.

FIG. 41 is a cross sectional view of a luminescent assembly according to a ninth embodiment of the invention.

FIG. 41A is a cross sectional view of a luminescent assembly according to a tenth embodiment of the invention.

FIG. 42 is a cross sectional view of a luminescent assembly according to an eleventh embodiment of the invention.

FIG. 42A is a perspective view of the light screen of FIG. 42.

FIG. 43 is a cross sectional view of a luminescent assembly according to a twelfth embodiment of the invention.

FIG. 44 is a cross sectional view of a luminescent assembly according to a thirteenth embodiment of the invention.

FIG. 45 is a cross sectional view of the light-emitting source of FIG. 44.

FIG. 46 is a perspective view of another light-emitting source of FIG. 44.

FIG. 47 is a cross sectional view of a luminescent assembly according to a fourteenth embodiment of the invention.

FIG. 48 is a cross sectional view of a luminescent assembly according to a fifteenth embodiment of the invention.

FIG. 49 is a cross sectional view of a luminescent assembly according to a sixteenth embodiment of the invention.

FIG. 49A is a cross sectional view of a luminescent assembly according to a seventeenth embodiment of the invention.

FIG. 50 is a cross sectional view of a luminescent assembly according to an eighteenth embodiment of the invention.

FIG. 51 is a top view of FIG. 50.

FIG. 52 is a schematic diagram illustrating another brightness-enhanced light-emitting structure of FIG. 50, whereas an addition ultraviolet-absorbing cap is disposed covering the light screen completely.

FIG. 53 is a schematic diagram illustrating yet another brightness-enhanced light-emitting structure of FIG. 50, whereas the semi-circular solid base is replaced by a semi-column solid base.

FIG. 54 is a schematic diagram illustrating further another brightness-enhanced light-emitting structure of FIG. 50.

FIG. 55 is a cross sectional view of a luminescent assembly according to a nineteenth embodiment of the invention.

FIG. 56 is a schematic diagram illustrating another brightness-enhanced light-emitting structure of FIG. 55.

FIG. 57 is a cross sectional view of a luminescent assembly according to a twentieth embodiment of the invention.

### DESCRIPTION OF THE PREFERRED EMBODIMENT

For your esteemed members of reviewing committee to further understand and recognize the fulfilled functions and structural characteristics of the invention, several preferable embodiments cooperating with detailed description are presented as the follows.

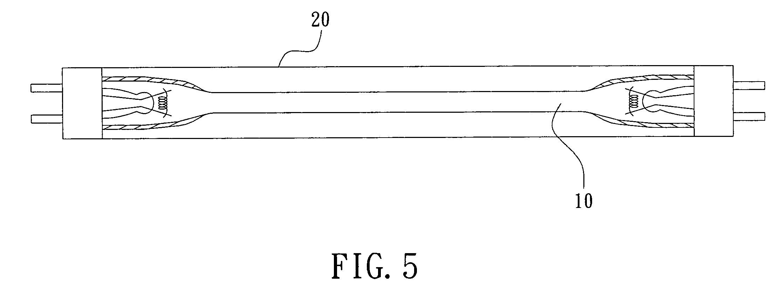

Please refer to FIG. 5, FIG. 6 and FIG. 7, which show a brightness-enhanced light-emitting structure of a luminescent assembly according to a first embodiment of the invention. The brightness-enhanced light-emitting structure of the first embodiment is comprised of:
a light-emitting source 10, being a bar-shaped tube capable of emitting an ultraviolet light or a blue light, having a cover layer 11 formed on a top portion of the inner circumference thereof, preferably, the cover layer being substantially a light reflecting layer; and
a light screen 20, being substantially a bar-shaped tube disposed surrounding the bar-shaped light-emitting source 10, having a primary visible light layer 21 formed at a portion of the inner surface of the light screen 20 at the position corresponding to a bottom portion of the circumference of the light-emitting source 10 where is not covered by the cover layer 11, preferably the primary visible light layer 21 being a fluorescent coating or a phosphorescent coating.

When the light-emitting source 10 is powered by electricity, it is driven to discharge a blue light or an ultraviolet light that the blue/ultraviolet light will irradiate out of the light-emitting source 10 from the side thereof where is not covered by the cover layer 11 and shine upon the primary visible light layer 21 disposed on the light screen 20 while exciting the same for emitting a visible light. As the excited visible light is discharged out of the light screen 20 from the side thereof where is not covered by the primary visible light layer 21, it is mostly excited form the surface of the primary visible light layer 21 and then the brightness is enhanced since it is not filtered by the primary visible light layer 21 before it is discharged as those are in the prior-art structure. Moreover, as the cover layer 11, being substantially a light reflecting layer, is formed at a the top portion of the inner circumference of the light-emitting source 10 at the position corresponding to the portion of the circumference of the light screen 20 where is covered by the primary visible light layer 21, the cover layer 11 is capable of blocking the harmful ultraviolet light and the same time being reflected to shine upon the primary visible light layer 21, and thus almost all the ultraviolet/blue light emitted from the light-emitting source 10 can be directed to shine upon the primary visible light layer 21 for exciting visible light, so that the brightness of the luminescent assembly of the first embodiment is greatly enhanced.

In addition, since the light-emitting source 10 with cover layer 11 is disposed at a position corresponding to the primary visible light layer 21 of the light screen 20, it is vital to have the area of the primary visible light layer 21 to be obviously larger than that of the light-emitting source 10, and the primary visible light layer 21 to be disposed a specific distance away from the cover layer 11 of the light-emitting source 10, such that the blue/ultraviolet light emitted from the light-emitting source 10 can shine on the primary visible light layer 21 sufficiently.

Furthermore, the cover layer 11, which is substantially a light reflecting layer formed on a top portion of the inner circumference of the light-emitting source 10, can be replaced by a fluorescent coating or phosphorescent coating. Thereby, not only the blue/ultraviolet light can be direct to shine on the primary visible light layer 21 while exciting visible light therefrom as described above, but also the blue/ultraviolet light shining on the cover layer 11 can excite another visible light to be discharged out of the light-emitting source 10 after penetrating and filtered by the cover layer 11.

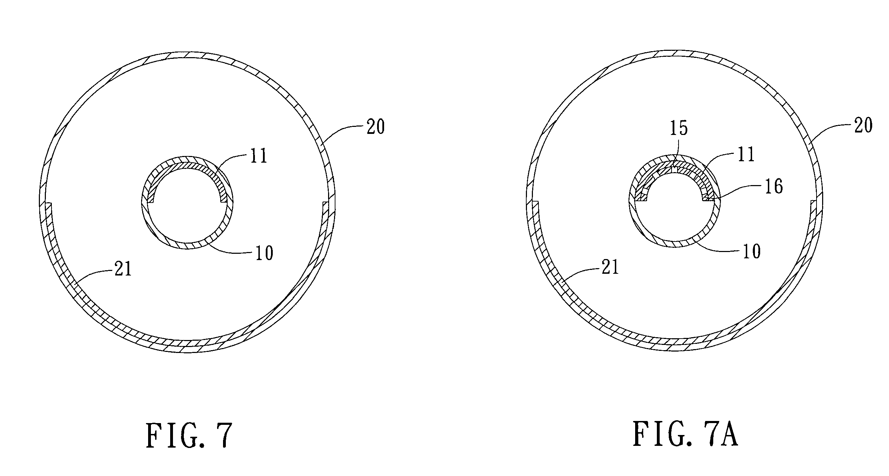

If the cover layer 11 is substantially a fluorescent coating or phosphorescent coating, it is preferred to arranged a light reflecting layer 16 with a plurality of holes 15 to be formed superimposing the fluorescent/phosphorescent coating of the cover layer 11, as shown in FIG. 7A. By the disposition of the light reflecting layer 16 with a plurality of holes 15, not only the blue/ultraviolet light can be direct to shine on the fluorescent/phosphorescent coating of the cover layer 11 through the plural holes 15 for exciting visible light to be discharged out of the light-emitting source 10 after penetrating and filtered by the cover layer 11 as described above, but also most of the blue/ultraviolet light shining on the cover layer 11 can be reflected and directed toward the primary visible light layer 21 and used for exciting more visible light therefrom, that is preferred since the visible light excited from the primary visible light layer 21 can discharge out of the luminescent assembly without being filtered by the primary visible light layer 21 and thus the brightness thereof is not reduced.

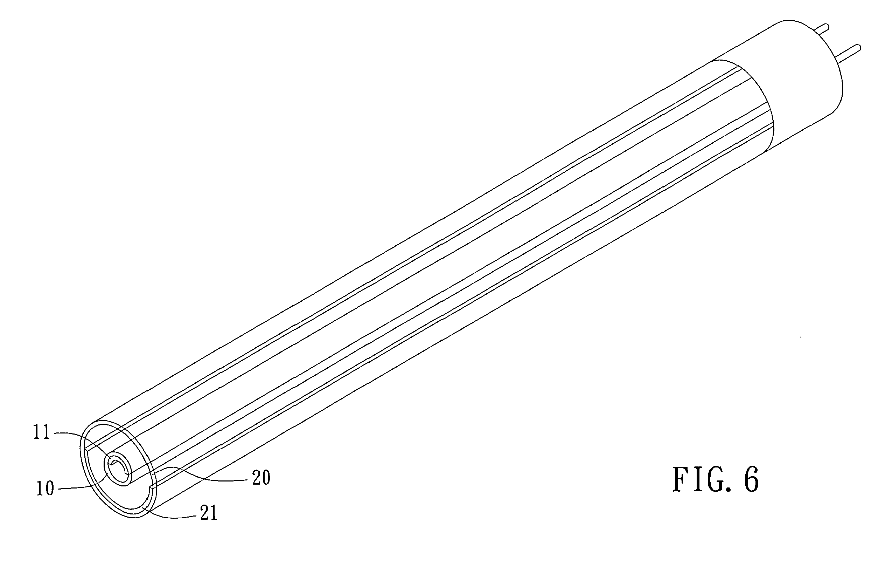

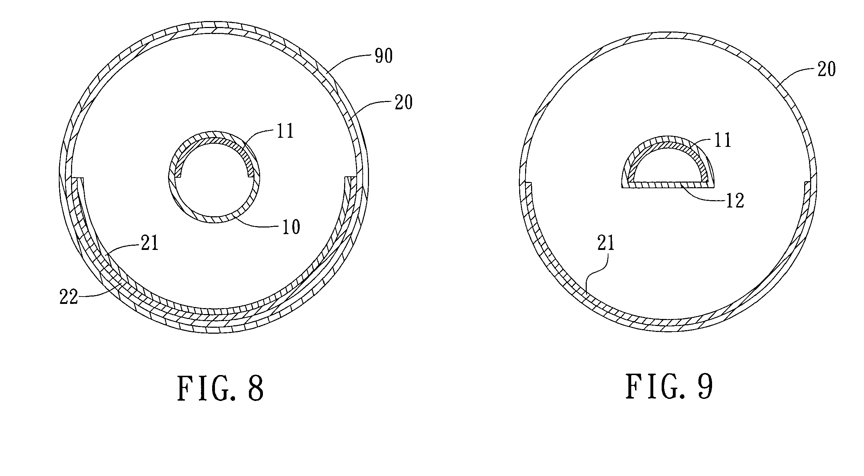

Please refer to FIG. 8, which is a cross sectional view of the brightness-enhanced light-emitting structure of FIG. 6 having an additional light reflecting layer sandwiched between the primary visible light layer and the inner circumference of the light screen. In FIG. 8, the primary visible light layer 21 is coated on a light reflecting layer 22 while the light reflecting layer 22 is disposed on a bottom portion of the inner circumference of the light screen 20. By sandwiching the light reflecting layer 22 between the primary visible light layer 21 and the inner circumference of the light screen 20, the visible light excited from the primary visible light layer 21 and penetrating the same can be prevented from irradiating out of the light screen 20 as it is reflected by the light reflecting layer 22. In addition, a cap 90, capable of absorbing ultraviolet light, is disposed on the outer circumference of the light screen 20 for absorbing the diffusing ultraviolet light.

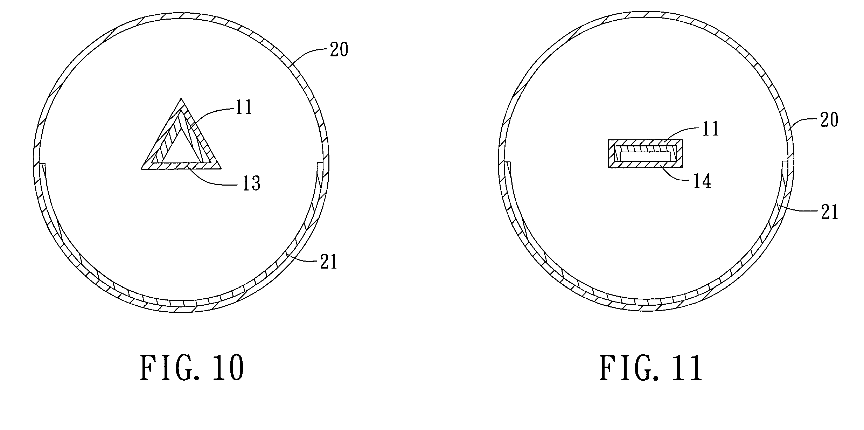

It is noted that the abovementioned embodiments are only used as illustrations while the structure of the invention is not limited thereby. It is known to those skilled in the art that every component mentioned in the abovementioned embodiments can be replaced and substituted by some other components of equal functionality. For instance, the light-emitting source 10 of circular cross section can be substituted by a light-emitting source 12 of semi-circular cross section as shown in FIG. 9, or by a light-emitting source 13 of triangular cross section as shown in FIG. 10, or by a light-emitting source 14 of rectangular cross section as shown in FIG. 11, or other light-emitting sources of polygonal cross section. Similarly, the light screen 20 of circular cross section can be replaced and substituted by a light screen semi-circular cross section, a light screen of triangular cross section, a light screen of rectangular cross section, or other light screens of polygonal cross section. The aforesaid replacements and substitutions are easy to implement by those skilled in the art and is protected by the appended claims of the invention. Furthermore, as the aforesaid replacements and substitutions will not affect and change the structure of the foregoing embodiments, so that detailed description of the aforesaid replacements and substitutions is waived.

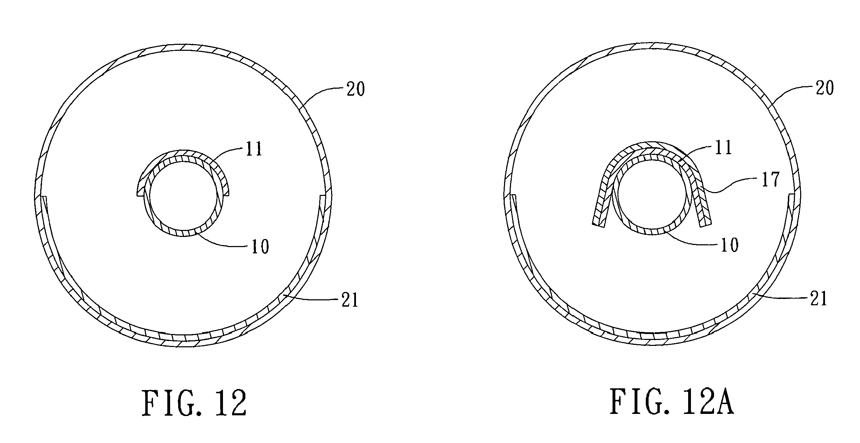

Please refer to FIG. 12, which is a cross section of another brightness-enhanced light-emitting structure used in the luminescent assembly of the first embodiment of the invention, whereas the cover layer is coated on the outer circumference of the light-emitting source thereof. The difference between the brightness-enhanced light-emitting structure of FIG. 12 and that of FIG. 7 is that the cover layer 11 is formed on a top portion of the outer circumference of the light-emitting source 10 instead of that used to form on the inner circumference thereof. In the brightness-enhanced light-emitting structure of FIG. 12, the cover layer 11 is substantially a light reflecting layer that is used for reflecting the blue/ultraviolet light shining on the cover layer 11 and directing the reflected blue/ultraviolet light toward the primary visible light layer 21 formed on the light screen 20. Thereby, most of the blue/ultraviolet light can shine on the primary visible light layer 21 and used for exciting more visible light therefrom, that is preferred since the visible light excited from the primary visible light layer 21 can discharge out of the luminescent assembly without being filtered and thus the brightness thereof is greatly enhanced.

Moreover, the light reflecting cover layer 11 can be replaced by the a light reflecting layer having a plurality of holes formed thereon while each is filled with a material selected from the group consisting of a fluorescence material and a phosphorescence material, by which some blue/ultraviolet light of the light-emitting source 10 can be reflected and directed to shine on the primary visible light layer 21 while other blue/ultraviolet light can shine of the fluorescence/phosphorescence material-filled holes for exciting visible light therefrom and discharging out of the luminescent assembly after penetrating and filtered by the cover layer 11. In addition, the cover layer 11 can be substantially a transparent cap 17 with an inner surface coated with a layer of fluorescent coating or phosphorescent coating, as seen in FIG. 12A, by which the cover layer 11 is acting similar to the primary visible light layer 21 other than that the visible light excited therefrom is filtered by the cover layer 11 itself before discharging out of the luminescent assembly. Similarly, a light reflecting layer, having a plurality of holes formed thereon while each filled with a material selected from the group consisting of a fluorescence material and a phosphorescence material, can be sandwiched between the fluorescent/phosphorescent coating of the transparent cap 17 and the outer circumference of the light-emitting source 10, or can be coated directly upon and superimposing the fluorescent/phosphorescent coating of the transparent cap 17, by which not only the blue/ultraviolet light can be direct to shine on the fluorescent/phosphorescent coating of the transparent cap 17 through the plural holes 15 filled with fluorescent/phosphorescent material for exciting visible light to be discharged out of the light-emitting source 10 after penetrating and filtered by the cover layer 11, but also most of the blue/ultraviolet light shining on the cover layer 11 can be reflected and directed toward the primary visible light layer 21 and used for exciting more visible light therefrom.

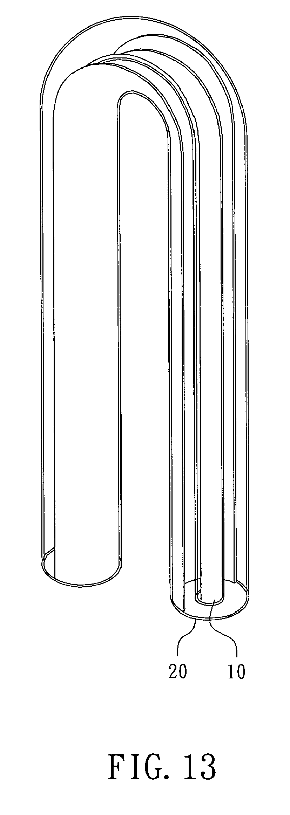

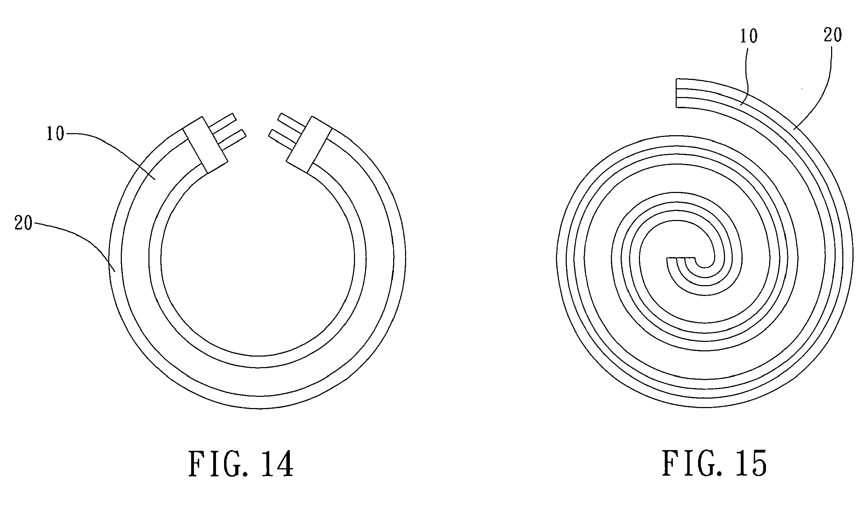

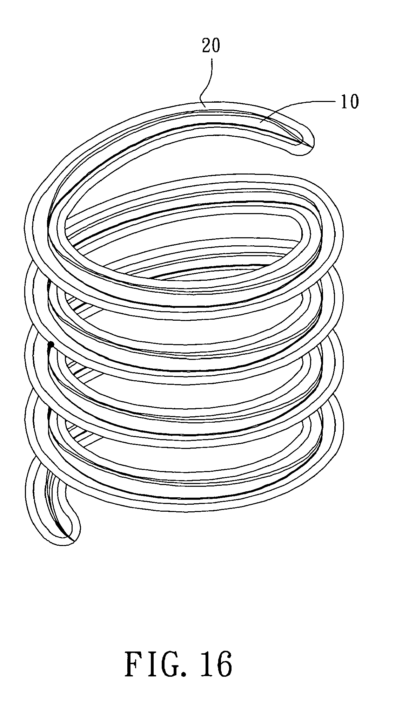

Please refer to FIG. 13, which shows an appearance of the luminescent assembly of FIG. 5. The luminescent assembly of FIG. 13 is simply the bending of the bar-shaped tube of the luminescent assembly of FIG. 5 into an U-shaped tube, that only the appearance is changed while the structure and functionality remain the same. Similarly, the appearance of the luminescent assembly can be formed in a shape of a circular tube, a planar spiral tube, a stereoscopic spiral tube, and a stereoscopic conical helix tube, as those shown in FIGs. 13, 14, 15, 16. However, there can be other appearances with affecting the structure and functionality, and thus are nit described further herein.

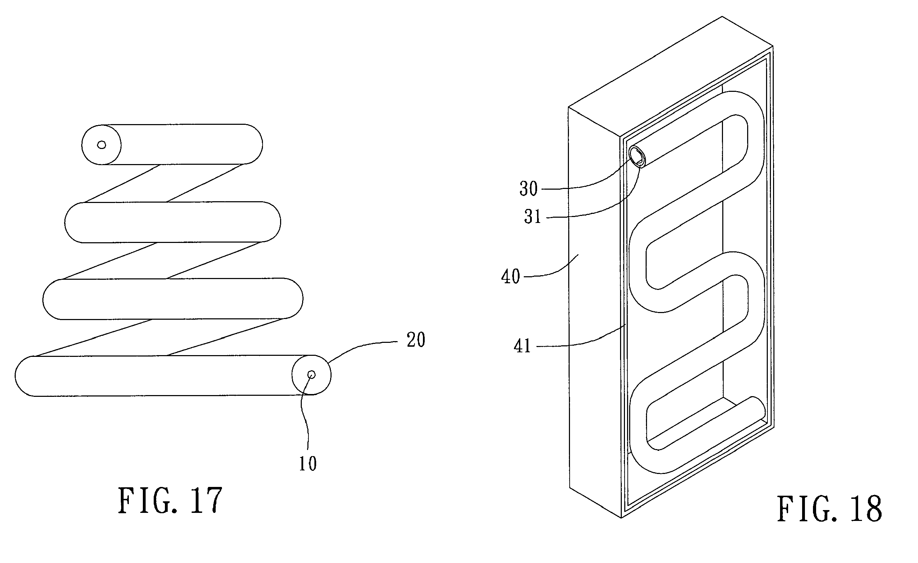

Please refer to FIG. 18, which is a schematic diagram showing a brightness-enhanced light-emitting structure of a luminescent assembly according to a second embodiment of the invention, whereas the light-emitting source can be in any shape while being received in a box-like light screen, and the cover layer is coated on the inner circumference of the light-emitting source thereof. The brightness-enhanced light-emitting structure of the second embodiment is comprised of: a light-emitting source 30, being a bar-shaped tube capable of emitting blue/ultraviolet light, having a cover layer 31 formed on a top portion of the inner circumference thereof; and a light screen 40, being a box having an opening formed at the top thereof, having a primary visible light layer 41 formed at the inner surfaces of the bottom and the sides of the box. Similar to that shown in the fist embodiment, the cover layer 31 is substantially a light reflecting layer, and the primary visible light layer 41 is substantially a fluorescent coating or a phosphorescent coating while an additional light reflecting layer can be disposed outside the fluorescent/phosphorescent coating for blocking and preventing the visible light excited therefrom from penetrating the primary visible light layer 41 and discharging out therefrom. In FIG. 18, the light-emitting source 30 is a jagged tube being placed at the top opening of the box-like light screen 40. Furthermore, the cover layer 31 formed on the top portion of the inner circumference of the light-emitting source 30 can be substantially a fluorescent coating or a phosphorescent coating, and if the cover layer 31 is substantially a fluorescent coating or a phosphorescent coating, it is preferred to arranged a light reflecting layer with a plurality of holes to be formed superimposing the fluorescent/phosphorescent coating of the cover layer 31.

Similar to that of the first embodiment shown in FIG. 7, when the light-emitting source 10 is powered by electricity, it is driven to discharge a blue light or an ultraviolet light that the blue/ultraviolet light will irradiate out of the light-emitting source 10 from the side thereof where is not covered by the cover layer 31 and shine upon the primary visible light layer 41 while exciting the same for emitting a visible light. As the excited visible light is discharged out of the light screen 40 from the side thereof where is not covered by the primary visible light layer 41, it is mostly excited form the surface of the primary visible light layer 41 and then the brightness is enhanced since it is not filtered by the primary visible light layer 41 before it is discharged as those are in the prior-art structure. Moreover, as the cover layer 31, is substantially a light reflecting layer, the cover layer 31 is capable of reflecting the blue/ultraviolet light to shine upon the primary visible light layer 41, and thus almost all the ultraviolet/blue light emitted from the light-emitting source 30 can be directed to shine upon the primary visible light layer 41 for exciting visible light, so that the brightness of the luminescent assembly of the second embodiment is greatly enhanced.

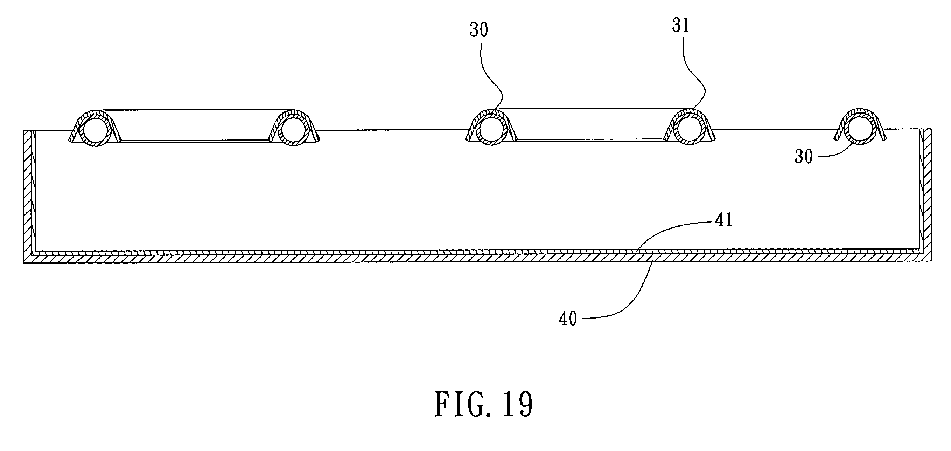

Please refer to FIG. 19, which is a schematic diagram showing another brightness-enhanced light-emitting structure of FIG. 18, whereas the cover layer is coated on the outer circumference of the light-emitting source thereof. The difference between the brightness-enhanced light-emitting structure of FIG. 19 and that of FIG. 18 is that the cover layer 31 is formed on a top portion of the outer circumference of the light-emitting source 30 instead of that used to form on the inner circumference thereof. Similar to that shown in the first embodiment, the cover layer 31 is substantially a layer selected from the group consisting of a light reflecting layer, a light reflecting layer with a plurality of holes formed thereon while each is filled with a material of a fluorescence material or a phosphorescence material, a transparent cap with an inner surface coated with a layer of fluorescent coating or phosphorescent coating, a transparent cap with an inner surface coated with a layer of fluorescent coating/phosphorescent coating while superimposing the fluorescent/phosphorescent coating by a light reflecting layer with a plurality of holes, and a transparent cap having a light reflecting layer with a plurality of holes coated directed on the inner surface thereof while each hole is filled by a fluorescence material or a phosphorescence material.

In addition, as those described in the first embodiment, the cross-section of light-emitting source 30 arranged at the top opening of the box-like light screen 40 can be in a shape selected from the group consisting of a circular, a semi-circular, a triangle, a rectangle and a polygon. Further, the appearance of the luminescent assembly using the brightness-enhanced light-emitting structure is formed in a shape selected from the group consisting of a bar-shaped tube, a U-shaped tube, a circular tube, and so on.

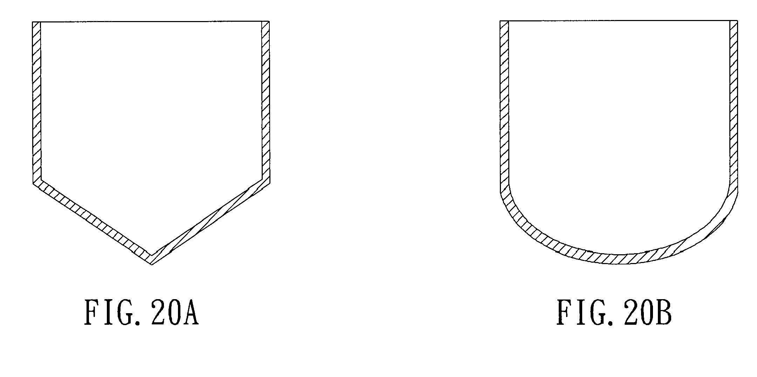

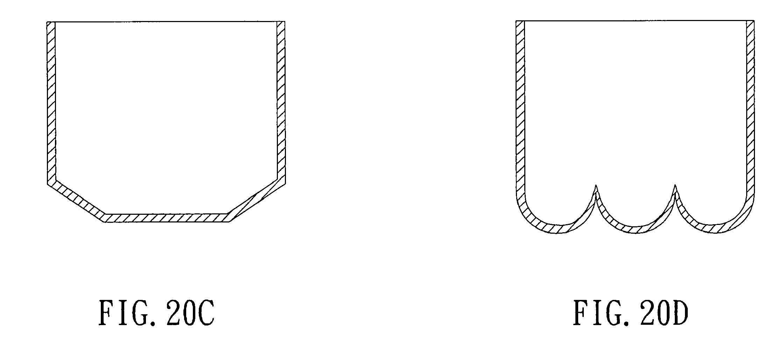

Moreover, the bottom of the transverse cross section of the light screen is in a shape selected from the group consisting of a straight line, a V-shape line, a jagged line, a single arc, a serial of interconnected arcs, as shown in FIG. 20A ~ FIG. 20D.

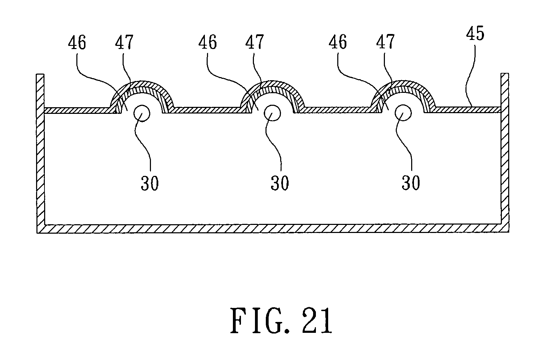

In a preferred aspect, there can be more than one light-emitting source 30being configured in the brightness-enhanced light-emitting structure of the invention. Furthermore, in order to further enhance the brightness of the luminescent assembly of the invention, an integrated transparent cap 45 is placed at a position of the at least one light-emitting source 30, as shown in FIG. 21. The integrated transparent cap has at least a recess 46, each formed at a bottom of the cap 45 for enabling each to received one of the at least one light-emitting source 30 and each having a cover layer 47 formed at an inner surface of the corresponding recess 46. Similar to that shown in the first embodiment, the cover layer 47 is substantially a layer selected from the group consisting of a light reflecting layer, a light reflecting layer with a plurality of holes formed thereon while each is filled with a material of a fluorescence material or a phosphorescence material, a transparent cap with an inner surface coated with a layer of fluorescent coating or phosphorescent coating, a transparent cap with an inner surface coated with a layer of fluorescent coating/phosphorescent coating while superimposing the fluorescent/phosphorescent coating by a light reflecting layer with a plurality of holes, and a transparent cap having a light reflecting layer with a plurality of holes coated directed on the inner surface thereof while each hole is filled by a fluorescence material or a phosphorescence material.

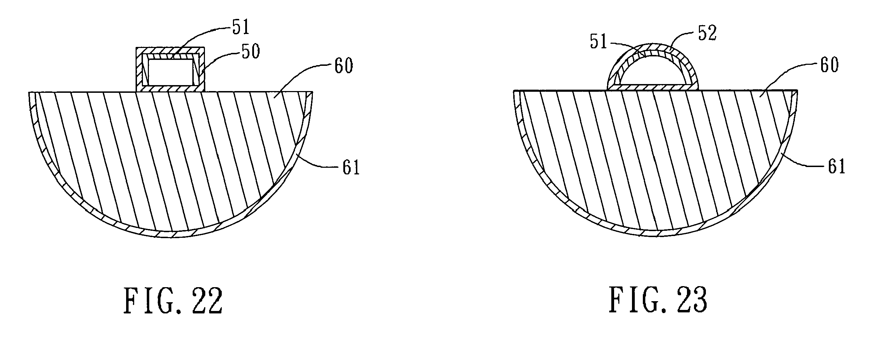

Please refer to FIG. 22, which is a cross sectional view of a brightness-enhanced light-emitting structure of a luminescent assembly according to a third embodiment of the invention, whereas the light screen is a solid semi-circular base and the cross section of the light-emitting source thereof is in a shape of a square. The brightness-enhanced light-emitting structure of the third embodiment is comprised of:
a light-emitting source 50, being a bar-shaped tube with rectangle cross section, capable of emitting ultraviolet or blue light, having a cover layer 51 formed on a top portion of the inner circumference thereof; and a light screen 60, being substantially a solid transparent base shaped like a semi-circular column, having a top surface capable of enabling the light-emitting source 50 to fix thereupon and a bottom with a primary visible light layer 61 formed thereon. In a preferred aspect, the cover layer 51 is substantially a light reflecting layer.

Similar to that shown in the first embodiment, the cover layer 51 formed on the top portion of the inner circumference of the light-emitting source 50 can be a substantially a fluorescent coating or a phosphorescent coating, and if the cover layer 51 is substantially a fluorescent coating or a phosphorescent coating, it is preferred to arranged a light reflecting layer with a plurality of holes to be formed superimposing the fluorescent/phosphorescent coating of the cover layer 31.

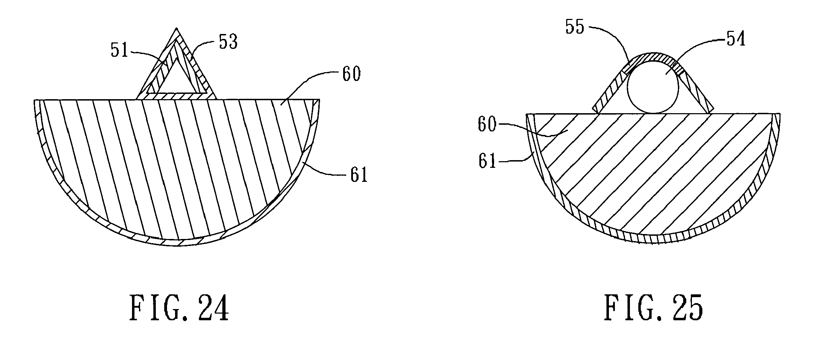

The aforesaid embodiment is only another illustration of the present invention, that the structure of the invention is not limited thereby. It is known to those skilled in the art that every component mentioned in the abovementioned embodiments can be replaced and substituted by some other components of equal functionality. For instance, the light-emitting source 50 of rectangular cross section can be substituted by a light-emitting source 52 of semi-circular cross section as shown in FIG. 23, or by a light-emitting source 33 of triangular cross section as shown in FIG. 24, or other light-emitting sources of polygonal cross section. The aforesaid replacements and substitutions are easy to implement by those skilled in the art and is protected by the appended claims of the invention. Furthermore, as the aforesaid replacements and substitutions will not affect and change the structure of the foregoing embodiments, so that detailed description of the aforesaid replacements and substitutions is waived.

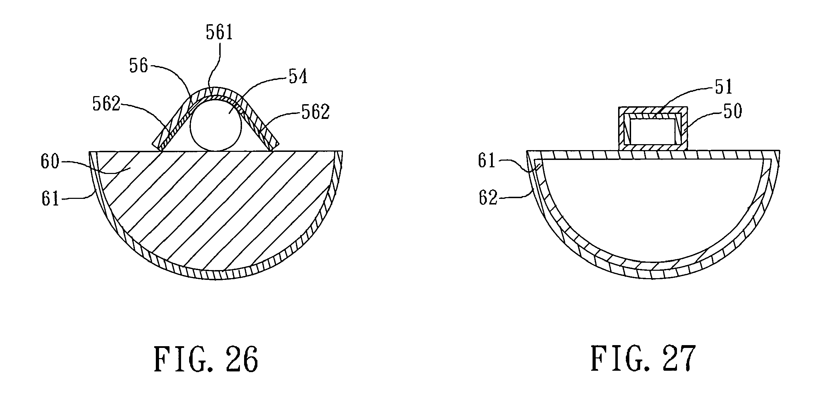

Moreover, the light-emitting source 50 of rectangular cross section can be substituted by a light-emitting source 54 of circular cross section as shown in FIG. 25. However, for the light-emitting source 54 of circular cross section, a special designed light reflecting layer 55 is required that is arranged outside the light-emitting source 54 and can cover the light-emitting source 54 of circular cross section completely for preventing any ultraviolet light from leaking out of the light reflecting layer 55. Thereby, all the ultraviolet light emitted from the light-emitting source 54 of circular cross section is reflected by the light reflecting layer 55 and thus shine on the primary visible light layer 61, so that no energy of the ultraviolet light emitted from the light-emitting source 54 is wasted and thus the brightness is enhanced. Similar to that described in the first embodiment, the light reflecting layer 55 can be formed with a plurality of holes while each is filled with a material selected from the group consisting of a fluorescence material and a phosphorescence material. Moreover, aforesaid light reflecting layer 55 can be replaced and substituted by a transparent cap 56 capable of covering the light-emitting source 54 of circular cross section completely, as shown in FIG. 26. In a preferred aspect, the transparent cap 56 can be formed as a transparent cap with an inner surface being completely covered by a fluorescent/phosphorescent coating 561, or as a transparent cap with an inner surface having a portion thereof being covered by a fluorescent/phosphorescent coating 561 while another portion being covered by a light reflecting layer 562. Similar to that shown in the first embodiment, a light reflecting layer, having a plurality of holes formed thereon while each filled with a material selected from the group consisting of a fluorescence material and a phosphorescence material, can be sandwiched between the fluorescent/phosphorescent coating of the transparent cap 56 and the outer circumference of the light-emitting source 54, or can be coated directly upon and superimposing the fluorescent/phosphorescent coating of the transparent cap 56.

In another preferred aspect, the light screen 60 formed as a solid transparent base of the aforesaid third embodiment can be replaced and substituted by a hollow base 62, shown in FIG. 27. The hollow base 62 can be completely made of a transparent material, or can be a base having only its top surface is made of a transparent material. Basically, the primary visible light layer 61 is coated on the inner circumference of the hollow base 62. However, if the hollow base 62 is completely transparent, the primary visible light layer 61 can be coated on the outer circumference of the hollow base 62. The aforesaid replacements and substitutions are easy to implement by those skilled in the art and is protected by the appended claims of the invention. Furthermore, as the aforesaid replacements and substitutions will not affect and change the structure of the foregoing embodiments, so that detailed description of the aforesaid replacements and substitutions is waived.

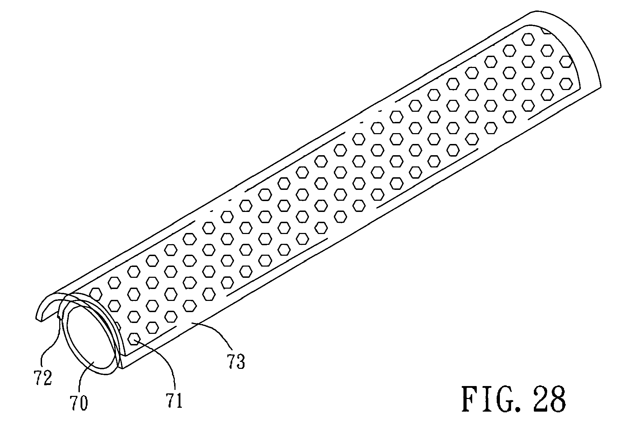

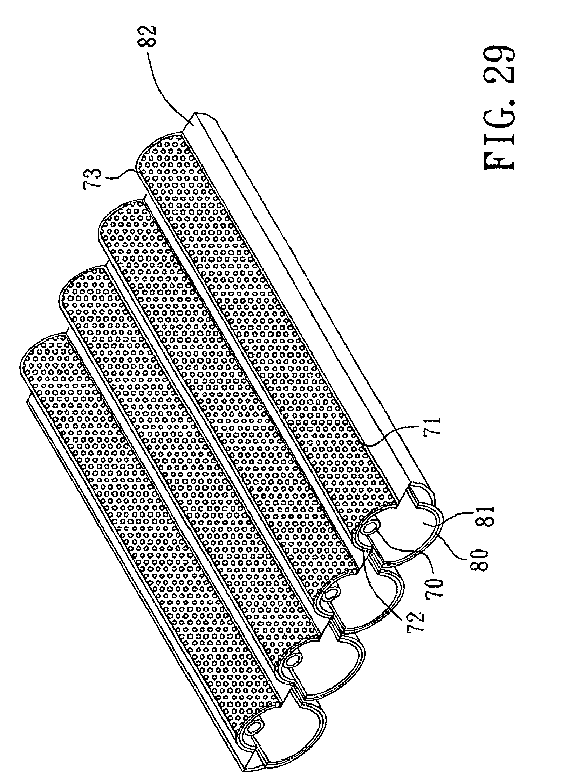

Please refer to FIG. 28 and FIG. 29, which are perspective views of a light-emitting source of a brightness-enhanced light-emitting structure according to a fourth embodiment of the invention. The brightness-enhanced light-emitting structure of the fourth embodiment is comprised of: at least a light-emitting source 70 and at least a light screen 80. A light reflecting layer 72 having a plurality of holes 71, each being filled with a material selected from the group consisting of a fluorescence material and a phosphorescence material, is placed over each corresponding light-emitting source 70 while each light reflecting layer 72 is adhered upon a transparent cover sheet 73. In a preferred aspect, if the plural holes 71 are nit filled by the selected fluorescence/phosphorescence material, the transparent cover sheet 73 should be coated by a fluorescent coating or a phosphorescent coating, so that the ultraviolet light of the light-emitting source 70 can be prevented from discharging out of the luminescent assembly through the plural holes 71 and irradiate directly upon human body. In the fourth embodiment of the invention, aside from positioning each light-emitting source 70 with the cover sheet 73 and the light reflecting layer 72 on a column-like transparent light screen 80 having a primary visible light layer 81 coated on the inner circumference thereof, a mask plate 82 made of a transparent material is arranged at the sides of each light-emitting source 70. As the ultraviolet/blue light of each light-emitting source 70 is reflected the light reflecting layer 72 and shine upon the primary visible light layer 81 of its corresponding light screen 80 for exciting the same to emit a visible light. As the excited visible light is discharged out of the light screen 80 from the side thereof where is not covered by the primary visible light layer 81, it is mostly excited form the surface of the primary visible light layer 81 and then the brightness is enhanced since it is not filtered by the primary visible light layer 81 before it is discharged and is guided by the mask plate 82 to discharge out of the luminescent assembly. Moreover, the ultraviolet/blue light of each light-emitting source 70 passing through the plural holes 71 of the light reflecting layer will either excited those fluorescent/phosphorescent coating filled in the plural holes 71, or those fluorescent/phosphorescent coated on the transparent cover sheet 73, whereas both cases will excite another visible light to be discharged out of the light-emitting source 70 after penetrating and filtered by the same. As most of the excited visible light is irradiated out of the luminescent assembly directly without being filtered, the brightness of the luminescent assembly is greatly enhanced.

Moreover, it is noted that the brightness of the visible light excited from the fluorescent/phosphorescent coating filled in the plural holes 71 of the light reflecting layer 72 can be varied with respect to the distance between the light reflecting layer and the light-emitting source 70, that is, for the same light reflecting layer 72, the brightness of he visible light excited from the fluorescent/phosphorescent coating filled in the plural holes 71 of the light reflecting layer 72 is reducing with the increasing of the distance between the light reflecting layer and the light-emitting source 70, and is enhancing with the decreasing of the distance between the light reflecting layer and the light-emitting source 70. Therefore, the homogeneity of brightness can be controlled by adjusting the size and density of the holes 71 arranging on the light reflecting layer 72.

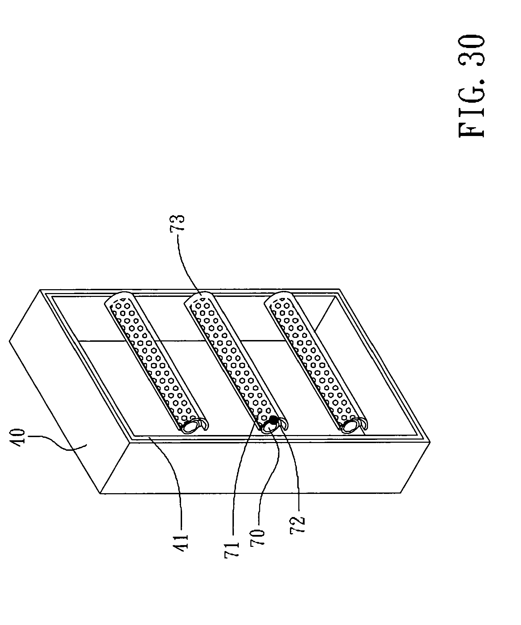

Please refer to FIG. 30, which is a perspective view of yet another brightness-enhanced light-emitting structure of FIG. 28. In FIG. 30, the brightness-enhanced light-emitting structure is being implemented in the luminescent assembly of the second embodiment, that is, by arranging the light-emitting source 70 of FIG. 28 into the box-like light screen 40 of the second embodiment shown in FIG. 18.

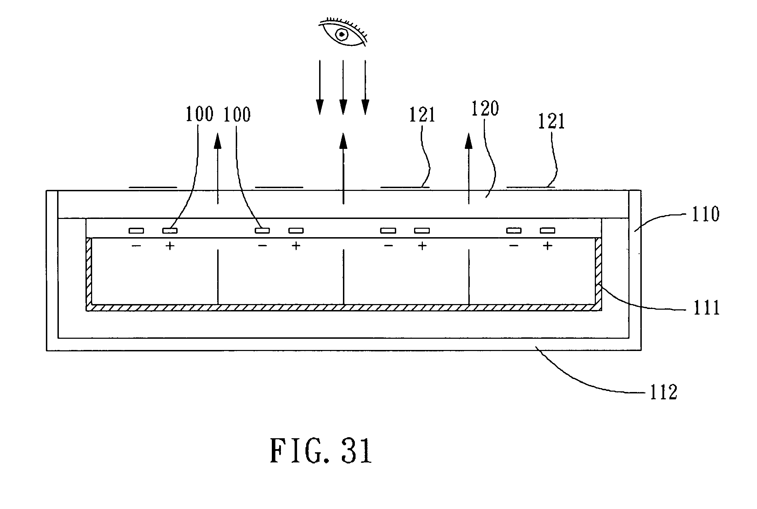

Please refer to FIG. 31, which is a schematic view of a brightness-enhanced light-emitting structure according to a fifth embodiment of the invention. The brightness-enhanced light-emitting structure of FIG. 31 is comprised of:
at least a light-emitting source 100, each composed of a pair of neighboring anode and cathode, each having a cover layer 121 formed directly over the top of the at least one light-emitting source 100; and
a light screen110, being substantially a top-opening hollow flat base, having a primary visible light layer 111 formed on every inner sides of the hollow flat base while enabling the least one light-emitting source 100 to be placed crossing over the top opening of the flat base;
a sealing cap 120, for covering and sealing the top opening of the light screen 110; and
an inert gas, filled in the hollow of the light screen 110.

When the least one light-emitting source 100 is electrically conducted, the electric power heats up the cathode of the light-emitting source 100 enough for it to emit electrons. These electrons collide with and ionize inert gas atoms to form a plasma by a process of impact ionization. As a result of avalanche ionization, the conductivity of the ionized gas rapidly rises, allowing higher currents to flow through the lamp, and thus causing it to emit light in the ultraviolet (UV) region. The UV light is absorbed by the primary visible light layer 111, which re-radiates the energy at lower frequencies to emit visible light while projecting the same out of the brightness-enhanced light-emitting structure through the sealing cap 120. Moreover, as the cover layer 121 is disposed on top of each light-emitting source 100, the excited UV light is blocked thereby for preventing it to shine directly on human body and cause damage. In a preferred aspect, the cover layer can be a fluorescent coating or a phosphorescent coating, that is can be excited to emit visible light, and thus further enhance the brightness of the brightness-enhanced light-emitting structure of FIG. 31.

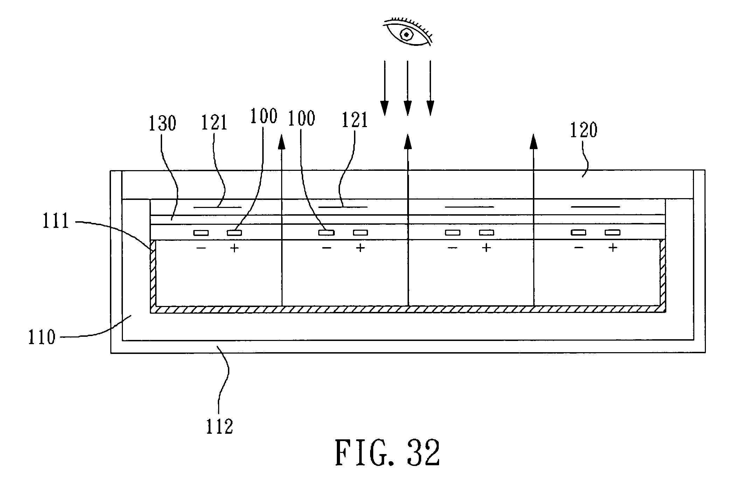

Please refer to FIG. 32, which is a schematic view of another brightness-enhanced light-emitting structure of FIG. 31, whereas the structure further has an additional insulating layer sandwiched between the light-emitting sources and the sealing cap. The difference between the brightness-enhanced light-emitting structure of FIG. 32 and that of FIG. 31 is that: a thin layer of insulating layer 130, made of quartz glass, is sandwiched between each light-emitting source 100 and the sealing cap 120, while enabling each cover layer 121 to be disposed directly on top of, or beneath the corresponding light-emitting source 100. As the insulating layer is made of a quartz glass, the sealing cap can be made of any ordinary transparent substrate so as to reduce cost.

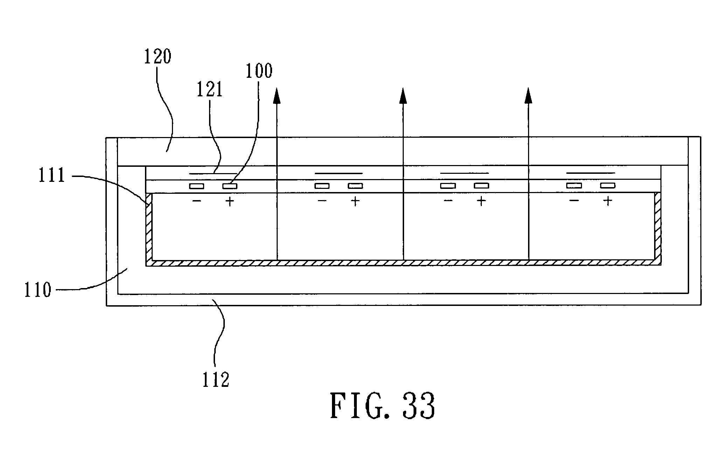

Please refer to FIG. 33, which is a schematic view of yet another brightness-enhanced light-emitting structure of FIG. 31. The difference between the brightness-enhanced light-emitting structure of FIG. 33 and that of FIG. 31 is that: the cover layer 121 is formed directly on top of the light-emitting sources 100.

In the aforesaid fifth embodiment, the light screen 110 and the sealing cap can be made of quartz glass, while an additional light reflecting layer 112 is formed at the outer circumference of the light screen 110, by which the excited visible light passing through the primary visible light layer 111 can be reflected and thus further enhancing the brightness of the brightness-enhanced light-emitting structure. In addition, the primary visible light layer 111 can be a phosphorescent coating, and the cover layer 121 not only can be replaced and substituted by either a phosphorescent coating or a light reflecting layer, but also can be a layer with a plurality of holes formed thereon while each hole is filled with either a fluorescence material or a phosphorescence material.

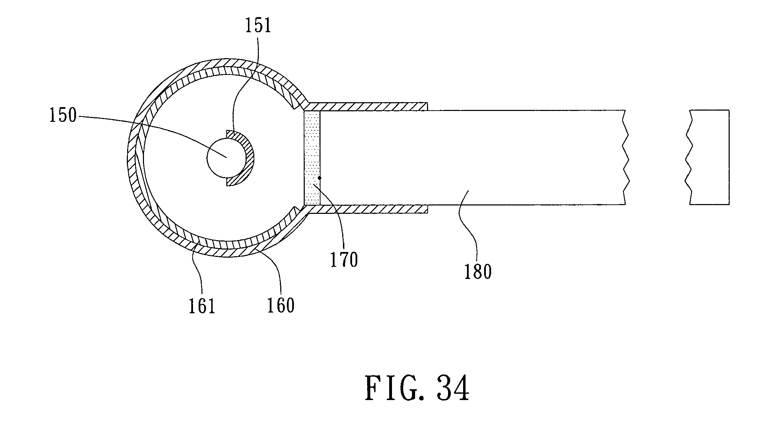

Please refer to FIG. 34, which is a schematic diagram showing a brightness-enhanced light-emitting structure of the invention, being used as the light source of a side-type backlight module of a liquid crystal display (LCD). In FIG. 31, the ultraviolet light of the light-emitting source 150 is completely being reflected and directed to shine on the primary visible light layer 161 disposed on the light screen 160. As the primary visible light layer 161 is substantially a fluorescent coating or a phosphorescent coating, the ultraviolet light can excite the primary visible light layer 161 to emit a visible light while projecting the same to the right. As the excited visible light is discharged directly without being filtered, the brightness of the same is preferred. After the excited visible light penetrates the ultraviolet-absorbing cap 170, it is guided by the light guide plate 180, arranged at the right of the light-emitting source 150, and shine on the back of the LCD, such that the brightness-enhanced light-emitting structure of the invention can be used as the light source of a side-type backlight module of a liquid crystal display (LCD).

Since the light-emitting source of the invention is capable of emitting blue or ultraviolet light, it is vital to dispose a ultraviolet-absorbing cap at a position corresponding to the projection of the excited visible light for absorbing residue ultraviolet light while permitting those discharged visible light to penetrate, so that the damage of ultraviolet can be prevented. In addition, each and every component used in the brightness-enhanced light-emitting structure of the invention, that is required to be penetrated by ultraviolet light, should be made of a material capable of permitting ultraviolet light to penetrate, such as anhydrous silica glass, synthetic quartz glass, or borosilicate glass.

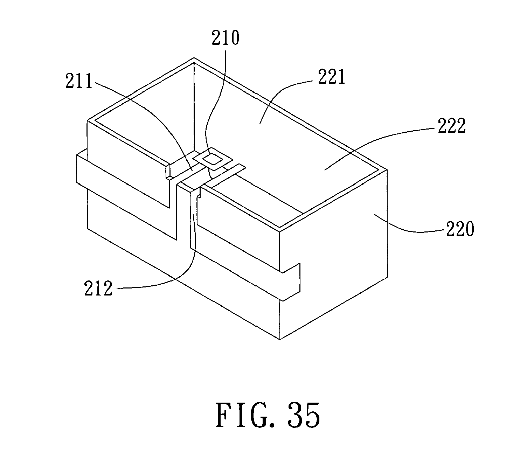

Please refer to FIG. 35, which is a schematic diagram showing a brightness-enhanced light-emitting structure for luminescent assembly according to a sixth embodiment of the invention. The brightness-enhanced light-emitting structure of FIG. 35 is comprised of: at least a light-emitting source 210, each being substantially a light emitting diode (LED) chip capable of emitting blue/ultraviolet (UV) light; and a light screen 220, being substantially a top-opening hollow box-like base, having a primary visible light layer 221, composed of a fluorescent coating or phosphorescent coating, formed on every inner sides and a bottom of the hollow box-like base while enabling the least one light-emitting source 210 to be arranged on the bottom thereof; wherein, the area of the primary visible light layer is obviously larger than that of the at least one light-emitting source; and a bottom of the primary visible light layer 221 is spaced from the at least one light-emitting source 210 by a specific distance for enabling the downward-irradiating UV light of the at least one light-emitting source to shine on the corresponding portion of the primary visible light layer 221 and thus exciting visible light therefrom.

In a preferred aspect, each light-emitting source 210 is fixedly arranged in a face-down manner at a position of a bottom surface of a first electrode plate 211, which is slightly larger than the LED chip 210, while connecting the anode and the cathode of the LED chip 210 by bonding wires respectively to the first electrode plate 211 and a second electrode plate 212 positioned neighboring to the first electrode plate 211. Moreover, a cover layer, composed of a light reflecting layer, is sandwiched between each light-emitting source 210 and the first electrode plate 211. It is noted that the cover layer can be an individual sheet-like structure, or can be structured as one of the following: being arranged directly at the bottom surface of the first electrode plate 211, and being integrated formed with the light reflecting layer formed at the top of the light-emitting source 210.

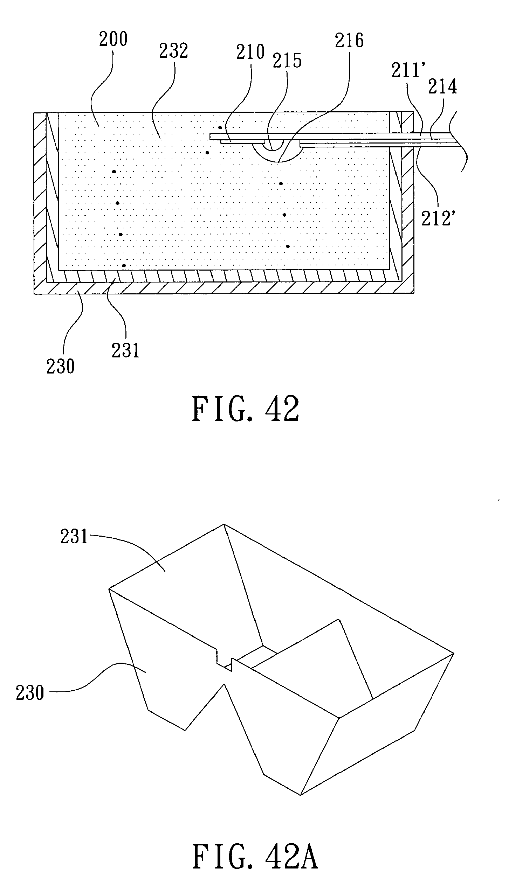

As the area of the first electrode plate 211 is larger than the LED chip 210, the direct upward-emitting UV light of the LED chip 210 is blocked thereby and thus the damage to human body is prevented. In addition, as the cover layer is positioned over each light-emitting source 210, the upward-emitting UV light of the LED chip 210 is reflected thereby and redirected to shine on the primary visible light layer 221 arranged on the light screen 220, and is used for exciting visible light in a surface excitation manner, by which the brightness of the brightness-enhanced light-emitting structure is enhanced. In a preferred aspect, when the at least one light-emitting source is a blue light LED chip, the hollow portion 222 of the light screen 220 can be filled by a transparent filling material, such as epoxy, as shown in FIG. 42.

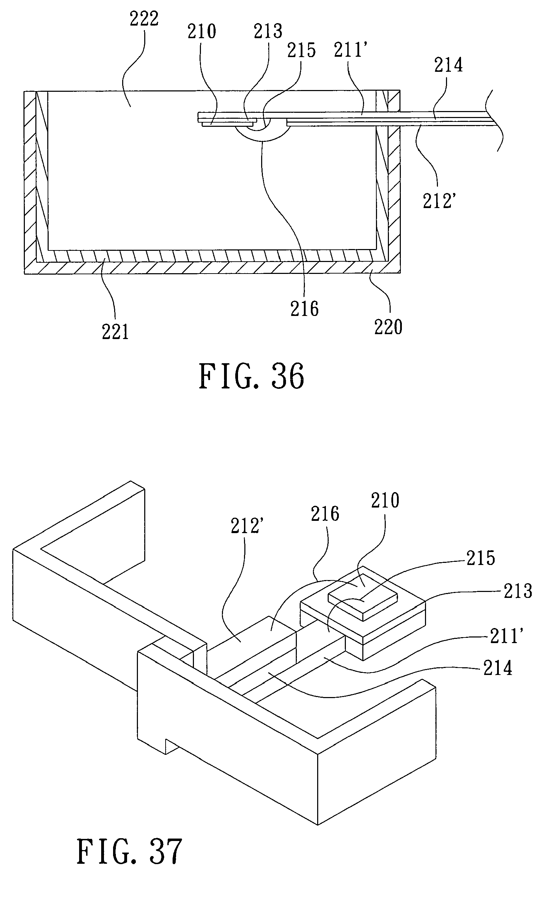

Please refer to FIG. 36 and FIG. 37, which are respectively a cross sectional view and a bottom view of a brightness-enhanced light-emitting structure for luminescent assembly according to a seventh embodiment of the invention. The difference between the brightness-enhanced light-emitting structure of the seventh embodiment and that of the first embodiment is that: although each light-emitting source 210 is also being fixedly arranged in a face-down manner at a position of a bottom surface of a first electrode plate 211', which is also is slightly larger than the light-emitting source 210, and also there is a cover layer 213, composed of a light reflecting layer, being sandwiched between the light-emitting source 210 and the first electrode plate 211, the second electrode plate 212' is arranged to directly under the first electrode plate 211' and overlaying the same, while sandwiching an insulating layer 214 therebetween for preventing shortage; and further, the light-emitting source 210 is electrically connected to the first electrode plate 211' and a second electrode plate 212' respectively by the two bonding wires 215, 216.

As seen in FIG. 37, the insulating layer 214 is sandwiched between the first electrode plate 211' and the second electrode plate 212' as a stacking structure. The insulating layer 214 should be made of certain non-conductive material, such as metal oxide, plastic, mica slices, etc. Furthermore, the light-emitting source 210 is disposed on the cover layer 213 formed on the bottom of the extending end of the first electrode plate 211', whereas the cover layer 213 is slighter larger than the light-emitting source 210 and is made of a light reflecting layer. The anode and cathode of the light-emitting source 210 is connected to the first electrode plate 211' and the second electrode plate 212' in respective by the two bonding wires 215, 216. It is noted that, by the stacking of the first and the second electrode plate 211', 212', the area in the brightness-enhanced light-emitting structure originally preserved for the second electrode plate 212' is saved and thus the amount of the visible light from the excitation of the primary visible light layer 211 being blocked by the electrode plate is reduced. In addition, by the stacking of the first and the second electrode plates 211', 212', the possibility of the bonding wires 215, 216 being ripped off by the relative displacement of the first and the second electrode plates 211', 212' can be reduced. In addition, if the anode of the light-emitting source 210 is arranged at the bottom thereof, the bonding wire 215 is no long required and only the bonding wire 216 is required to be connected; and it is the same to the cathode, that are known to those skilled in the art and thus is not described further hereinafter.

Similar to that mentioned in the sixth embodiment, the cover layer 213, composed of a light reflecting layer, can be an individual sheet-like structure, and also it can be structured as one of the following: being arranged directly at the bottom surface of the first electrode plate 211', and being integrated formed with the light reflecting layer formed at the top of the light-emitting source 210.

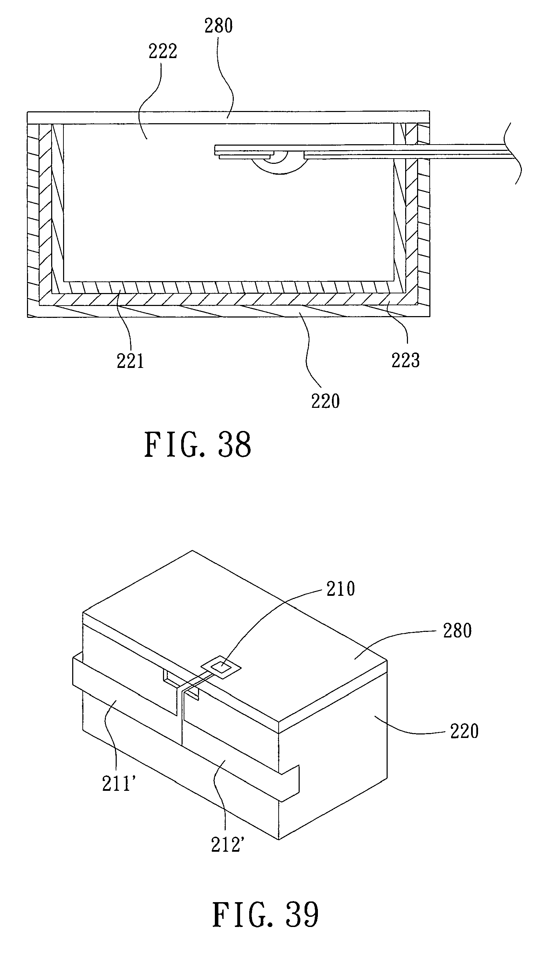

Moreover, when the light-emitting source 210 is an ultraviolet light LED chop, a portion of the UV light emitting therefrom might be reflected by the primary visible light layer 221, that the portion may be minimum, but still may cause damage to human body as being illuminated for a certain period of time. Therefore, in order to prevent the aforesaid condition, a transparent ultraviolet-absorbing cap 280 is arranged at a position with respect to the top-opening of the light screen 220, as shown in FIG. 38 and FIG. 39. Please refer to FIG. 38 and FIG. 39, which are respectively is a cross sectional view and a perspective view of a luminescent assembly according to an eighth embodiment of the invention. The transparent ultraviolet-absorbing cap 280 can be made of a transparent glass, since ordinary glass usually contain little metallic component that can filter most UV light while allowing visible light to pass through. In addition, as seen in FIG. 38, the primary visible light layer 221 not only comprises a fluorescent coating or a phosphorescent coating, but also it further comprises a light reflecting layer 223 formed at the exterior of the aforesaid fluorescent/phosphorescent coating, or it can substantially be a light screen, made of light reflecting material, having an inner surface coated with at least one of the aforesaid coatings.

However, as seen in FIG. 36, the light screen 220 is also made of a transparent material, such as glass, but the inner surface thereof is only coated by a fluorescent/phosphorescent coating without a coating of an additional light reflecting layer. Therefore, the visible light excited from the primary visible light layer is omni-directional that is suitable for omni-directional illuminating applications.

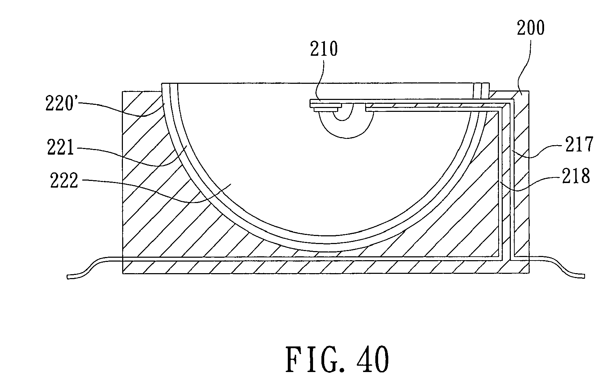

It is noted that the abovementioned embodiments are only used as illustrations while the structure of the invention is not limited thereby. It is known to those skilled in the art that every component mentioned in the abovementioned embodiments can be replaced and substituted by some other components of equal functionality. For instance, the top-opening hollow box-like base 220 can be substituted by a base selected from the group consisting of a box-like base of any shape, a semi-sphere base (as shown in FIG. 40), a semi-column base, a rectangular base, a trapezoid base, a polygonal base, a W-shaped base, a semi-sphere transparent base, a semi-column transparent base, a rectangular transparent base, a trapezoid transparent base, a polygonal transparent base, and a W-shaped transparent base. The aforesaid replacements and substitutions are easy to implement by those skilled in the art and is protected by the appended claims of the invention. Furthermore, as the aforesaid replacements and substitutions will not affect and change the structure of the foregoing embodiments, so that detailed description of the aforesaid replacements and substitutions is waived.

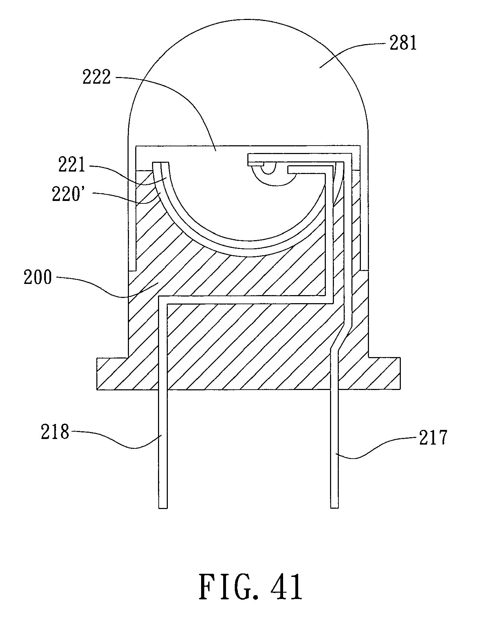

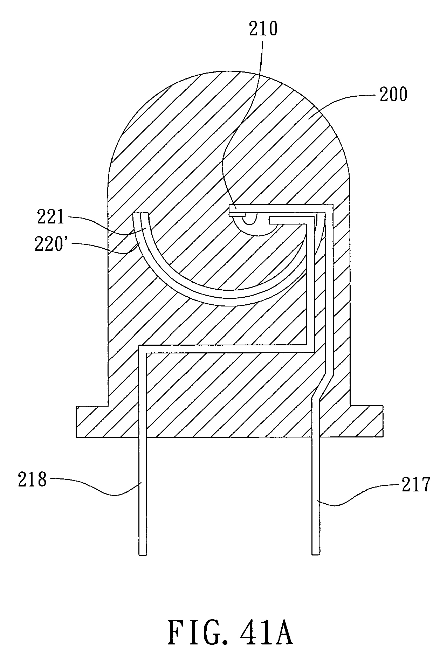

Please refer to FIG. 41, which is a cross sectional view of a luminescent assembly according to a ninth embodiment of the invention. In FIG. 41, the light-emitting source is a lamp-type UV light LED chip, that is structured similar to the seventh embodiment shown in FIG. 36, but with differences that its light screen 220' is substantially a semi-sphere base instead of the box-like base, and the outer ends of its electrode plates 217, 218 are exposed in the open while the other portion thereof are sealed and packaged by a filling material 200, such as epoxy. In addition, a transparent ultraviolet-absorbing cap 281 of arc-like head is covered on the LED chip such that a lamp-type LED with light collimation ability is achieved.

Please refer to FIG. 41A, which is a cross sectional view of a luminescent assembly according to a tenth embodiment of the invention. In FIG. 41, the light-emitting source is a lamp-type blue light LED chip, that it is different from the ninth embodiment of FIG. 41 in that: after the sealing and packaging by the filling material, the hollow portion 222 of FIG. 40 is not filled, but in FIG. 41, it is filled and thus a solid sphere is achieved. Therefore, the visible light excited from the primary visible light layer 221 can be further collimated by the semi-sphere light screen 220 and thus a brighter light is discharged.

Please refer to FIG. 42, which is a cross sectional view of a luminescent assembly according to an eleventh embodiment of the invention. The embodiment of FIG. 42 is similar to the first, the second and the third embodiments, but with a difference that the front view of its light screen 230 is in a W-shape while the side view thereof is a rectangle, as seen in FIG. 42A. In this embodiment, as the visible light excited from the primary visible light layer 231 is directed to discharge out of the light screen 230 from its top-opening and the brightest area is the place directly under the light-emitting source 210, the W-shaped light screen can enable the visible light of the brightest area to be discharge in a slanted manner so that they are less likely to be blocked by the two electrode plates 211', 212'.

In a preferred aspect, if the light-emitting sources 210 of the aforesaid embodiments are UV-light LED chips, a transparent ultraviolet-absorbing cap is required to be disposed at the top-opening of the light screen. However, if it is a blue light LED chip, the ultraviolet-absorbing cap is not required. In addition, when it is a blue light LED chip, for securing the two electrode plates and the bonding wires while saving the additional securing process, the hollow portion 232 of the light screen 230 is filled by the filling material 200, as seen in FIG. 42. That is, by filling the filling material 200 inside the light screen 230, the light-emitting source 210, the bonding wires 215, 216, the first and the second electrode plats 211', 212' and the primary visible light layer 231 made of fluorescent/phosphorescent coating are sealed and packaged all in once, such that the achieved structure can endure larger impact.

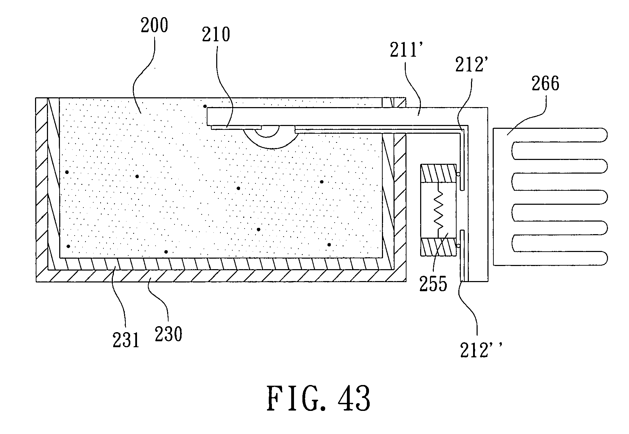

Please refer to FIG. 43, which is a cross sectional view of a brightness-enhanced light-emitting structure for luminescent assembly according to a twelfth embodiment of the invention. The structure of the twelfth embodiment is similar to that of FIG. 42, and the only difference between the two is that: the brightness-enhanced light-emitting structure of the twelfth embodiment has a current-limiting resistor 255 and a heat dissipator 266. As the light-emitting source 210 is arranged on the first electrode plate 211' that most of the heat generated therefrom will be conducted by the first electrode plate 211', by arranging the heat dissipator 266 on the first electrode plate 211', working temperature of the brightness-enhanced light-emitting structure can be reduced and thus the life span thereof is prolonged. In addition, the current-limiting resistor 255 is considered to be a required component of any LED chip, since LED chip without the current-limiting resistor 255 can easily burn out when there are variation in its power supply. Moreover, as parallel-connecting a plurality of LED chips, the forward drop of different LED are not the same that certain larger power might burn out those LED with smaller forward drop in the parallel connection in a blink of second if there is no current-limiting resistor connected thereto. In this embodiment, a small surface-mount-device (SMD) current-limiting resistor 255 is serially connected to the two second electrode plates 212', 212".

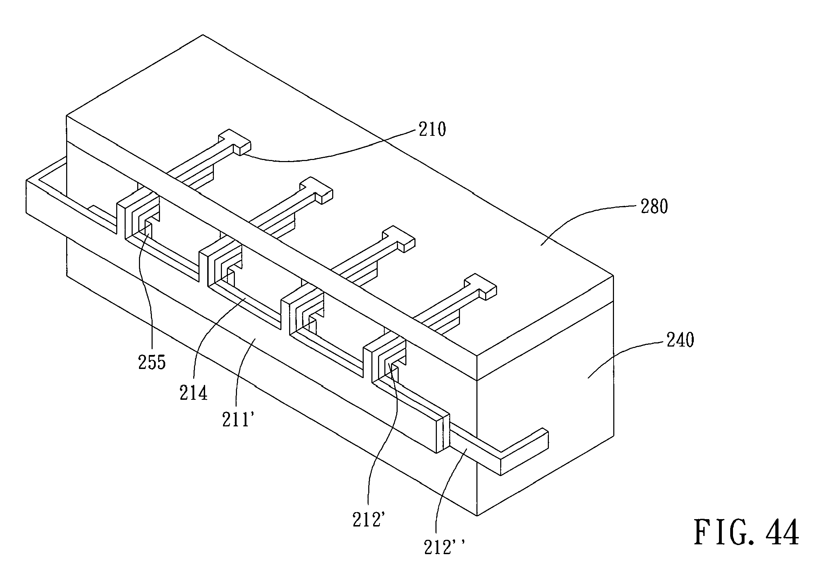

Please refer to FIG. 44, which is a cross sectional view of a brightness-enhanced light-emitting structure for luminescent assembly according to a thirteenth embodiment of the invention. The structure of the twelfth embodiment is similar to that of FIG. 43, and the only difference between the two is that: there are a plurality of light-emitting sources 210' arranged inside a light screen 240, while enabling a plural first electrode plates 211' to be parallel-connected to each other and extending outside the light screen 240, and enabling a plural second electrode plate 212' to extend outside the light screen 240 to be connected to a same second electrode plate 212" by a corresponding current-limiting resistor 255 in respective. Thus, by providing power to one of the plural first electrode plate 211' and the second electrode plate 212", all the light-emitting sources 210 are ignited.

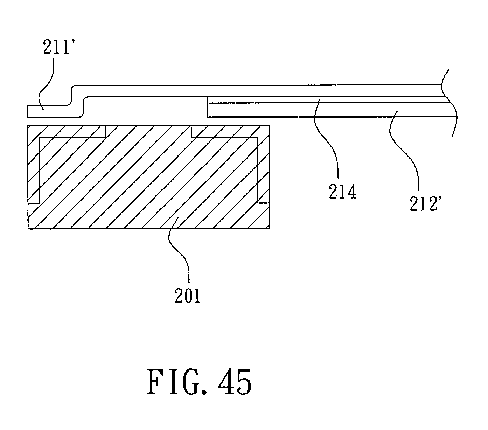

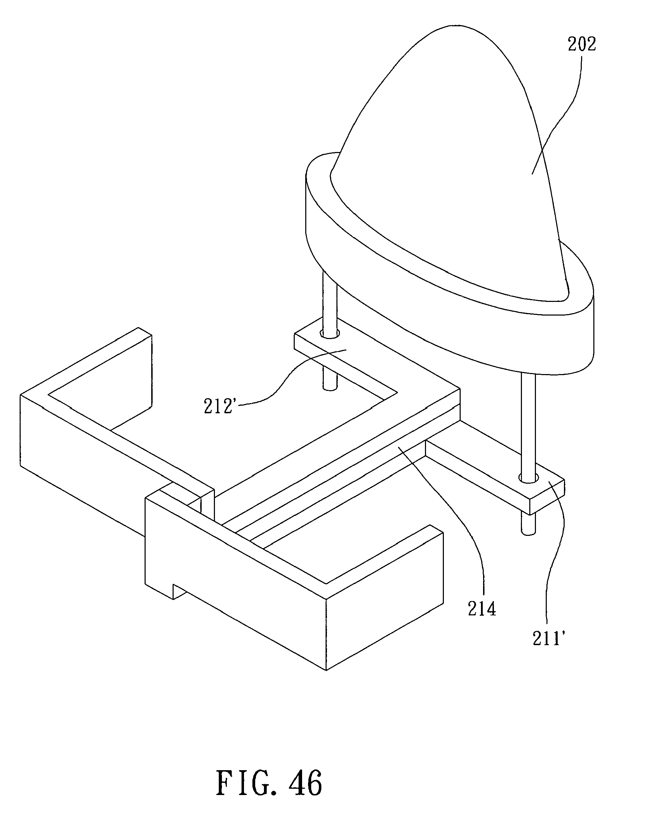

When there are a plurality of LED chip parallel-connected in a brightness-enhanced light-emitting structure, for facilitating maintenance, SMD LEDs or lamp-type LEDs are adopted and are arranged in an manner that requires a slight adjustment to the electrode plates of FIG. 44, as shown in FIG. 45. In FIG. 45, a SMD blue/UV light LED 201 is disposed in a face-down manner while connecting its anode and cathode respectively to the first electrode plate 211' and the second electrode plate 212'. It is noted that the edge of the first electrode plate 211' is bended slightly for enabling the bended portion to be parallel to the second electrode plate 212' such that the securing of the light-emitting source thereon can be facilitated. In FIG. 46, a lamp-type blue/UV light LED 202 is disposed in a face-down manner while connecting its anode and cathode respectively to the first electrode plate 211' and the second electrode plate 212'.

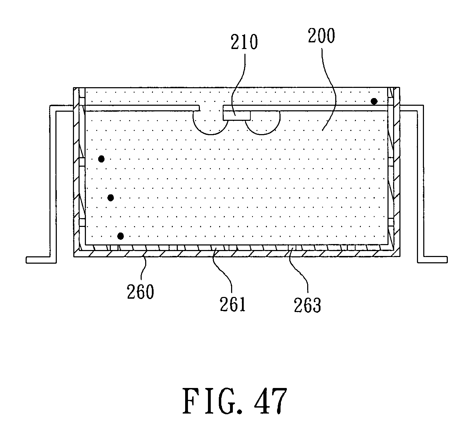

Please refer to FIG. 47, which is a cross sectional view of a brightness-enhanced light-emitting structure for luminescent assembly according to a fourteenth embodiment of the invention. The embodiment is different in that: the light-emitting source 210, being a blue light LED chip, is sealed inside the hollow of the light screen 260, and the primary visible light layer 261 is a fluorescent/phosphorescent coating with a plurality of holes 263, while a light reflecting layer is formed outside the aforesaid coating, whereas the size and distribution density of the holes can be varied with respect to actual requirement. Thereby, as the primary visible light layer 261 is excited in a surface excitation manner, the color temperature of the excited visible light can be adjusted by the plural holes 263. since the plural holes are substantially dots in the primary visible light layer 261 that are not covered by the fluorescent/phosphorescent coating, the light reflecting layer corresponding to those dots will reflect the blue light of the light-emitting source which is further mixed with the yellow light excited from the fluorescent/phosphorescent coating to generate white light. It noted that the sealing of the filling material, such as epoxy, used in the present embodiment is also applicable for other brightness-enhanced light-emitting structure using blue-light LED.

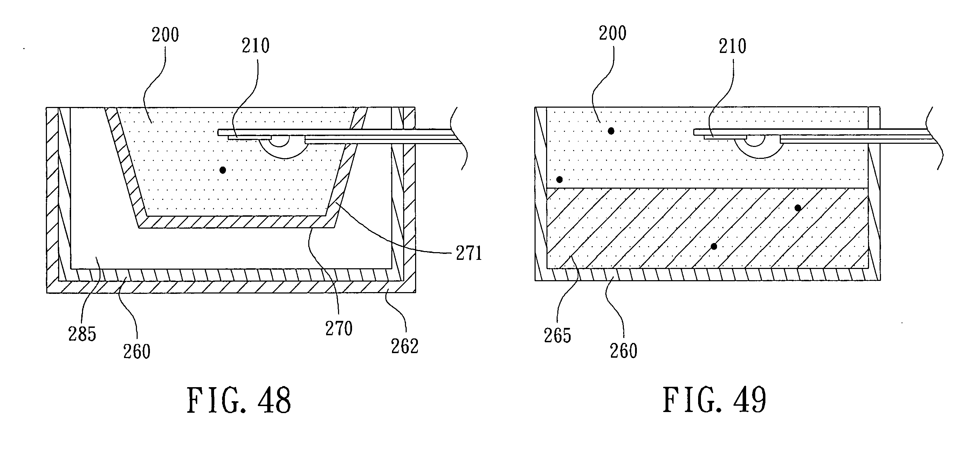

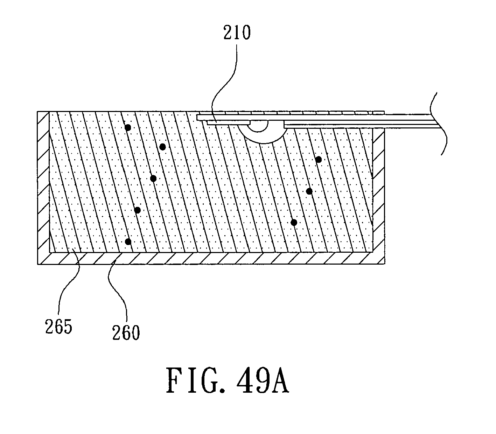

Please refer to FIG. 48, which is a cross sectional view of a brightness-enhanced light-emitting structure for luminescent assembly according to a fifteenth embodiment of the invention. Other than that shown in FIG. 47, the brightness-enhanced light-emitting structure further comprises a transparent block 285 with a central concave 270, wherein a light-emitting source 210 is received and sealed in the central concave 270 by a filling material 200, such as epoxy, while a primary visible light layer 271, composed of a fluorescent/phosphorescent coating, is formed on every inner walls of the central concave 270. In addition, a light reflecting layer is formed outside the outer wall of the light screen 260.

In FIG. 48, not only the blue light of the light-emitting source 210 will shine on the primary visible light layer 271 for exciting the same to discharge visible light in the surface excitation manner, but also the it will travel across the primary visible light layer 271 while exciting visible light therein, and the thus excited visible light will be reflected by the light reflecting layer 262 to be discharge through the transparent block 285 for additionally enhancing the brightness of the brightness-enhanced light-emitting structure.

Please refer to FIG. 49, which is a cross sectional view of a luminescent assembly according to a sixteenth embodiment of the invention. The primary visible light layer 265 of FIG. 49 is coated in the hollow of the light screen 260 by a specific thickness while the primary visible light layer 265 is made of a mixture of a resin and a fluorescence/phosphorescence material. Moreover, the light-emitting source 210 of FIG, 49 is packaged and arranged at the top of the hollow portion of the primary visible light layer 265 by a filling material 200, such as epoxy.

As the blue light of the light-emitting source 210 is able to shine directly on the primary visible light layer 265 made of a mixture of a resin and a fluorescence/phosphorescence material for exiting visible light therefrom, the brightness of the brightness-enhanced light-emitting structure is enhanced. It noted that the sealing of the filling material used in the present embodiment is also applicable for other brightness-enhanced light-emitting structure using blue-light LED.

Please refer to FIG. 49A, is a cross sectional view of a brightness-enhanced light-emitting structure for luminescent assembly according to a seventeenth embodiment of the invention. Other than that shown in FIG. 49, the interior of the light screen 260 is filled by a primary visible light layer 265 made by a mixture of a resin and a fluorescence/phosphorescence material. As the primary visible light layer 265 is thicker comparing to that shown in FIG. 49 and the light-emitting source 210 is still spaced form the bottom of the primary visible layer 265 by a specific distance, the density of the fluorescence/phosphorescence material of the mixture can be smaller for enabling the thickened primary visible layer 265 to act the same as that of FIG, 49. Moreover, since the aforesaid embodiment is structured similar to the prior art, it is comparatively easy to implement. As the blue light of the light-emitting source 210 is downward shining on the thickened primary visible layer 265, the fluorescence/phosphorescence material disposed the closer to the light-emitting source 210, the brighter it will be. Thus, when the brightness-enhanced light-emitting structure of FIG. 49A is view from above, it appears to be illuminated in the surface excitation manner. It noted that the sealing of the epoxy used in the present embodiment is also applicable for other brightness-enhanced light-emitting structure using blue-light LED.

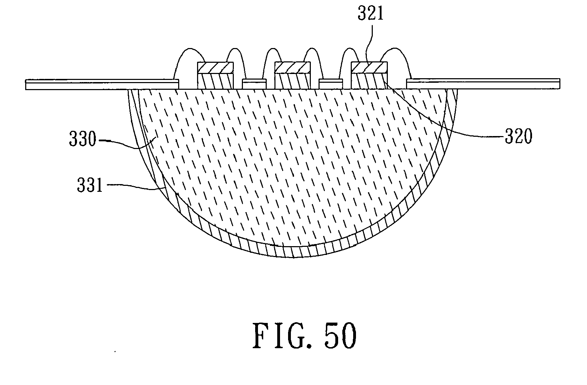

Please refer to FIG. 50 to FIG. 52, which are schematic diagrams showing a brightness-enhanced light-emitting structure for luminescent assembly according to an eighteenth embodiment of the invention. The brightness-enhanced light-emitting structure comprises:
at least a light-emitting source 320, each being substantially a blue/UV light LED chip having a cover layer 320, composed of a light reflecting layer, arranged at the top thereof; and
a light screen 330, being substantially a transparent semi-sphere solid base, having a primary visible light layer 331 coated on the bottom surface thereof while providing a top surface thereof for each light-emitting source 320 to fixed thereon;
wherein, the primary visible light layer 331 is substantially a fluorescent/phosphorescent coating; and the area of the primary visible light layer 331 is obviously larger than that of the at least one light-emitting source 320 while primary visible light layer 331 is spaced from the at least one light-emitting source 320 by a specific distance for enabling the downward-irradiating blue/UV light of the at least one light-emitting source 320 to shine on the corresponding portion of the primary visible light layer 331 and thus exciting visible light therefrom.

As on top of each light-emitting source 320, there is a cover layer 321 made of a light reflecting layer, the blue/UV light of each light-emitting source 320, being generated as soon as each being conducted, will be directed to irradiate directly downward to shine on the primary visible light layer 331 of the light screen 330 for exciting visible light therefrom in the surface excitation manner. The cover layer 321 not only can block the upward irradiating UV/blue light from discharging outside the brightness-enhanced light-emitting structure, but also it can further reflect and redirect those UV/blue light toward the primary visible light layer 331 for exciting more visible light, and thus enhancing the brightness of the brightness-enhanced light-emitting structure.

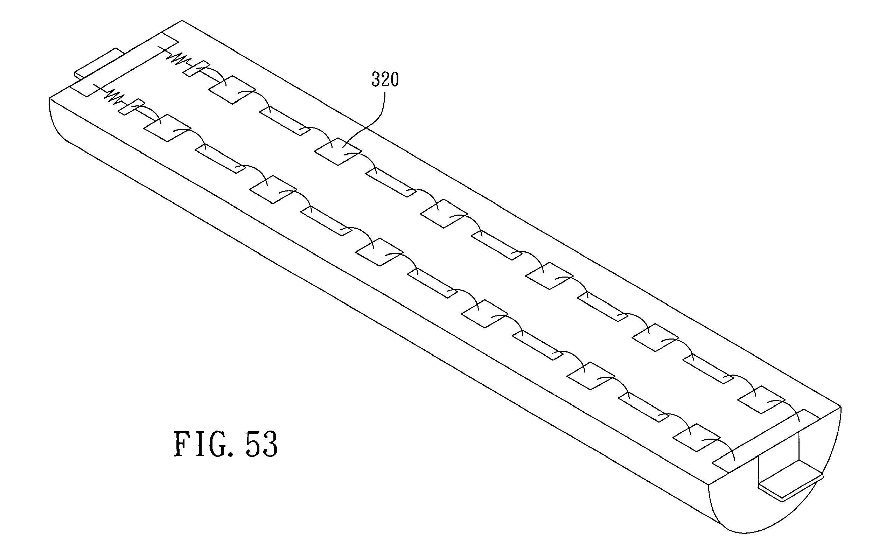

It is noted that the abovementioned embodiments are only used as illustrations while the structure of the invention is not limited thereby. It is known to those skilled in the art that every component mentioned in the abovementioned embodiments can be replaced and substituted by some other components of equal functionality. For instance, the transparent semi-sphere solid base can be substituted by a base selected from the group consisting of a transparent semi-column solid base (as shown in FIG. 53), a transparent rectangular solid base, a transparent trapezoid solid base, a transparent polygonal solid base, a transparent semi-sphere hollow base, a transparent semi-column hollow base, a transparent rectangular hollow base, a transparent trapezoid hollow base, and a transparent polygonal hollow base. The aforesaid replacements and substitutions are easy to implement by those skilled in the art and is protected by the appended claims of the invention. Furthermore, as the aforesaid replacements and substitutions will not affect and change the structure of the foregoing embodiments, so that detailed description of the aforesaid replacements and substitutions is waived.

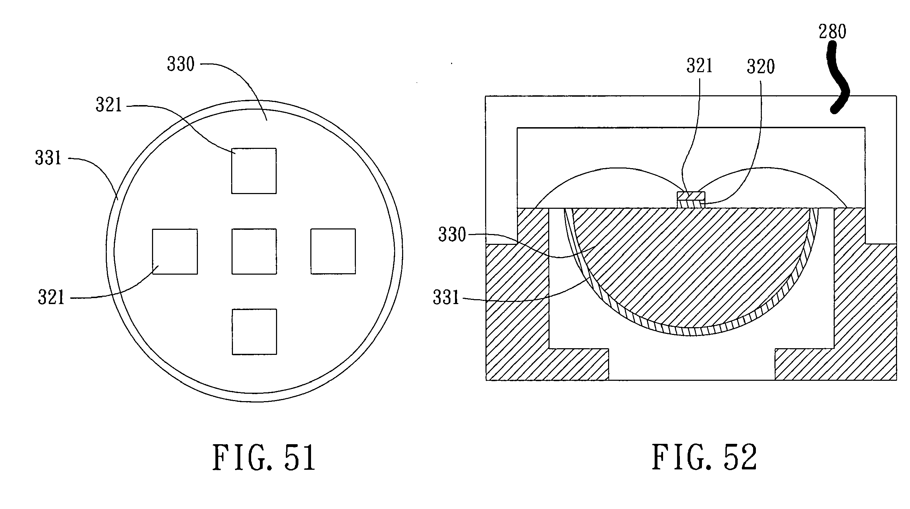

As the light-emitting source 320 of FIG. 52 is a SMD LED chip, it is preferred to install a ultraviolet-absorbing cap 280 covering the light screen 330 completely so that the damage of human body and apparatuses caused by the illumination of UV light can be prevented. In addition, the cover layer 321 can be replaced and substituted by a fluorescent/phosphorescent coating such that it not only can be excited to illuminate by the blue/UV light in the surface excitation manner, but also the blue/UV light can travel through the cover layer while exciting visible light deep in the layer, by which the brightness of the brightness-enhanced light-emitting structure is enhanced comparing to those of prior arts.

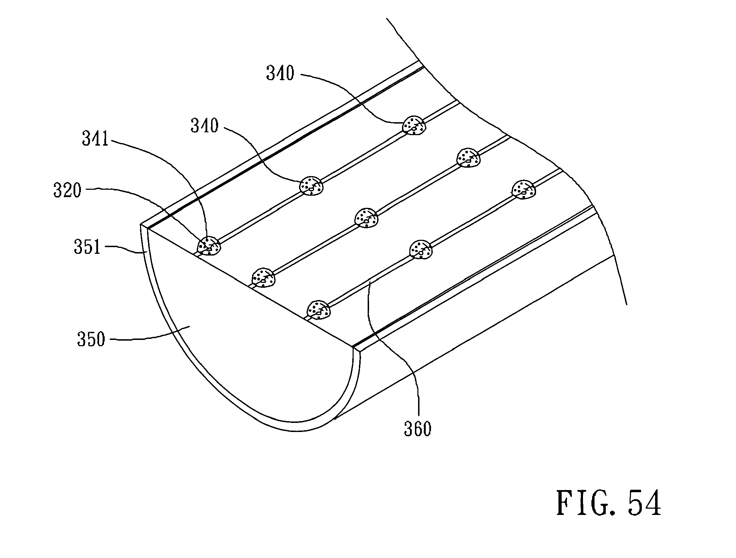

Please refer to FIG. 54, which is a schematic diagram illustrating further another brightness-enhanced light-emitting structure of FIG. 50. The brightness-enhanced light-emitting structure comprises:
at least a light-emitting source 320, each being substantially a blue/UV light LED chip having a cover layer 340, composed of a light reflecting layer, arranged at the top thereof; and
a light screen 350, being substantially a transparent solid base, having a primary visible light layer 351 coated on the bottom surface thereof while providing a top surface thereof for each light-emitting source 320 to fixed thereon;
wherein, the primary visible light layer 351 is substantially a fluorescent/phosphorescent coating; and the area of the primary visible light layer 351 is obviously larger than that of the at least one light-emitting source 320 projected on the primary visible light layer 351 while primary visible light layer 351 is spaced from the at least one light-emitting source 320 by a specific distance for enabling the downward-irradiating blue/UV light of the at least one light-emitting source 320 to shine on the corresponding portion of the primary visible light layer 351 and thus exciting visible light therefrom.

As on top of each light-emitting source 320, there is a cover layer 321 made of a light reflecting layer, the blue/UV light of each light-emitting source 320, being generated as soon as each being conducted by the conducting of lead frames 360 or wires, will be irradiate either downward to shine on the primary visible light layer 351 of the light screen 330 or upward to shine on the cover layer 340. Thus, as the blue/UV light irradiate on the cover layer 240 will be reflected and redirected to shine to shine on the primary visible light layer 351, it can be concluded that almost all the blue/UV light of the light-emitting source 320 are directed to shine on the primary visible light layer 351 for exciting visible light therefrom in the surface excitation manner and thus the brightness of the brightness-enhanced light-emitting structure is enhanced. In addition, as the cover layer 321 can effectively block the upward irradiating UV/blue light from discharging outside the brightness-enhanced light-emitting structure, the damage to human body can be prevented. Moreover, in a preferred aspect, a plurality of holes 341 can be formed on the cover layer 340 which are filled with a fluorescence or phosphorescence materials, by which a potion of the upward irradiating UV/blue light is reflected to shine on the primary visible light layer 351 while the other portion of the upward irradiating UV/blue light is traveling through the holes 341 of the cover layer 340 and exciting visible light therewith. By adjusting the distribution density and the size of the holes 341, it is possible to enable the brightness of the cover layer to approaching that of the primary visible light layer 351, so that the shadow caused by the cover layer 340 can be eliminated since the illumination of the luminous assembly is appeared to be more homogeneous, and thus the brightness is enhanced.

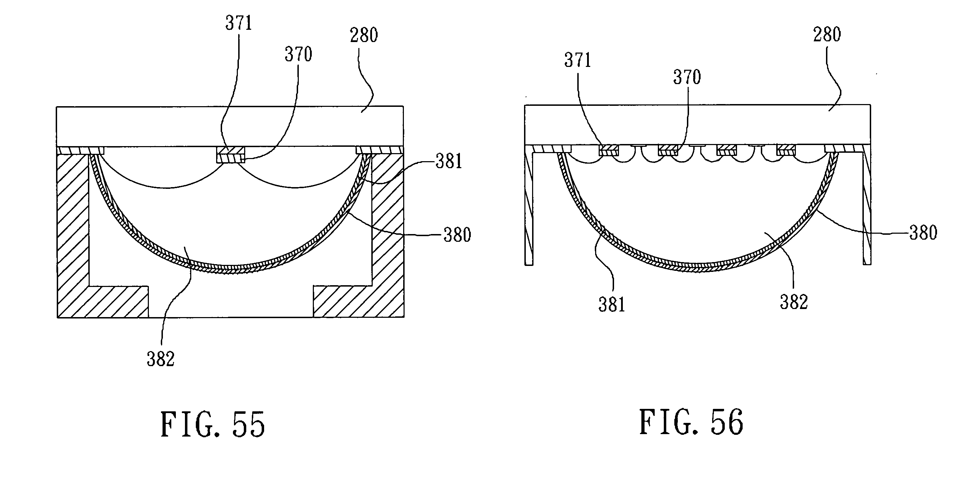

Please refer to FIG. 55 to FIG. 56, which are schematic diagrams showing a brightness-enhanced light-emitting structure for luminescent assembly according to a nineteenth embodiment of the invention. The brightness-enhanced light-emitting structure comprises:
at least a light-emitting source 370, each being substantially a SMD blue/UV light LED chip having a cover layer 371, composed of a light reflecting layer, arranged at the top thereof; and
a light screen 380, being substantially a bowl-like base, having a primary visible light layer 351 coated on the bottom circumference thereof; and
a ultraviolet-absorbing cap 280, covering the top-opening of the bowl-like base 380 while providing a bottom surface thereof for enabling the cover layer 371 of the at least one light-emitting source 370 to affix thereon;
wherein, the primary visible light layer 381 is substantially a fluorescent/phosphorescent coating; and the area of the primary visible light layer 351 is obviously larger than that of the at least one light-emitting source 370 while primary visible light layer 381 is spaced from the at least one light-emitting source 370 by a specific distance for enabling the downward-irradiating blue/UV light of the at least one light-emitting source 370 to shine on the corresponding portion of the primary visible light layer 351 and thus exciting visible light therefrom.

As on top of each light-emitting source 370, there is a cover layer 371 made of a light reflecting layer, the blue/UV light of each light-emitting source 370, being generated as soon as each being conducted, will be directed to irradiate directly downward to shine on the primary visible light layer 381 of the light screen 380 for exciting visible light therefrom and shine upwardly in the surface excitation manner. The cover layer 371 not only can block the upward irradiating UV/blue light from discharging outside the brightness-enhanced light-emitting structure, but also it can further reflect and redirect those UV/blue light toward the primary visible light layer 381 for exciting more visible light, and thus enhancing the brightness of the brightness-enhanced light-emitting structure.

In addition, the cover layer 321 can be replaced and substituted by a fluorescent/phosphorescent coating such that it not only can be excited to illuminate by the blue/UV light in the surface excitation manner, but also the blue/UV light can travel through the cover layer while exciting visible light deep in the layer, by which the brightness of the brightness-enhanced light-emitting structure is enhanced comparing to those of prior arts.

Moreover, if the light-emitting source 370 is a blue light LED chip, the hollow portion 382 of the bowl-like base can be sealed by a transparent filling material, such as epoxy, or can be sealed similar to those shown in FIG. 49 and FIG. 49A.

As seen in FIG. 50, FIG. 53, FIG. 54 and FIG. 56, the wires or lead frames 360, used for enabling electric conducting, can be partially being coating by a layer of Indium-Tin-Oxide (ITO) so that the blocking of the primary visible light layer can be reduced.

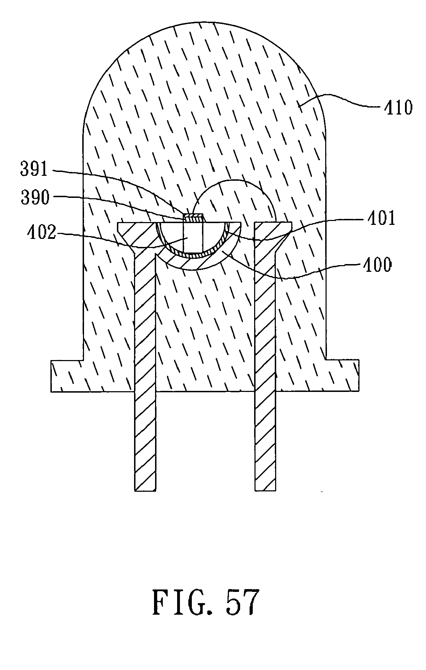

Please refer to FIG. 57, which is a cross sectional view of a brightness-enhanced light-emitting structure for luminescent assembly according to a twentieth embodiment of the invention. The brightness-enhanced light-emitting structure of FIG. 57 comprises:
a light-emitting source 390, being substantially a blue light LED chip having a cover layer 391, composed of a light reflecting layer, arranged at the top thereof; and
a light screen 400, being substantially a bowl-like base, having a primary visible light layer 401 coated on the bottom circumference thereof while providing a transparent supporting member 402 for the light-emitting source 390 to affix thereon; and
a package member 410, for packing the light-emitting source 390 and the light screen 400 into a complete block, and being generally made of a transparent filling material, such as epoxy.

It is noted that, in order to enhance the brightness of the aforesaid brightness-enhanced light-emitting structure, the visible light excited from the primary visible light layer 401 by the blue light of the light-emitting source should be discharge out of the package member 410 without being filtered thereby.

Therefore, the area of the primary visible light layer 401 should be obviously larger than that of the light-emitting source 390 while primary visible light layer 401 should be spaced from the light-emitting source 390 by a specific distance for enabling the downward-irradiating blue light of the light-emitting source 390 to shine on the corresponding portion of the primary visible light layer 401 and thus exciting visible light therefrom. In addition, by the use of the transparent supporting member 402, the light-emitting source 390 can be spaced from the light screen 400 by a specific distance, such that most of the visible light excited from the primary visible light layer 401 will not be block by the cover layer 391 and the light-emitting source 390. That is, by the disposition of the transparent supporting member 402, the cover layer 391 as well as the light-emitting source 390 covered thereby are all being kept away from the primary visible light layer 401 far enough that the blue light of the light-emitting source 390 can shine sufficiently on the primary visible light layer 401 for exciting visible light therefrom, and thus the brightness is enhanced.

In a description of "a light screen, having a primary visible light layer formed on every inner sides and a bottom thereof, while enabling the least one light-emitting source to be arranged on the bottom thereof; wherein the area of the primary visible light layer is obviously larger than that of the light-emitting source while primary visible light layer is spaced from the light-emitting source by a specific distance for enabling the downward-irradiating blue/UV light of the light-emitting source to shine on the corresponding portion of the primary visible light layer sufficiently and thus exciting visible light therefrom" with respect to some of the aforesaid embodiments, one can realize that the light-emitting source is fixedly disposed on top of the primary visible light layer and spaced from the same by a specific distance, however, it is not limited to the position directly on top of the primary visible light layer, it can be position at any position over the primary visible light layer only if it can satisfied the restriction disclosed in the foregoing description that enables the downward-irradiating blue/UV light of the light-emitting source to shine on the corresponding portion of the primary visible light layer sufficiently and thus exciting visible light therefrom. In addition, the "sufficient" illumination of blue/UV light on the primary visible light layer can be realized as the following: the downward irradiating blue/UV light of the light-emitting can illuminate not only the bottom of the light screen, but also the side walls of the light screen, that is, every inner surfaces of the light screen underneath the light-emitting source.

Since the light-emitting source of the invention is capable of emitting blue or ultraviolet light, it is vital to dispose a ultraviolet-absorbing cap at a position corresponding to the projection of the excited visible light for absorbing residue ultraviolet light while permitting those discharged visible light to penetrate, so that the damage of ultraviolet can be prevented. In addition, each and every component used in the brightness-enhanced light-emitting structure of the invention, that is required to be penetrated by ultraviolet light, should be made of a material capable of permitting ultraviolet light to penetrate, such as anhydrous silica glass, synthetic quartz glass, or borosilicate glass.

It is noted that, as oxide and nitrogen can be easily converted by ultraviolet light into ozone, Nitrogen monoxide, and nitrogen dioxide, and so on, that those gases are not only harmful to human body, but also will exhaust the energy of the ultraviolet light. Therefore, it is intended to seal the area of the brightness-enhanced light-emitting structure that is illuminated by ultraviolet light in an airtight manner while filling the airtight area with an inert gas. However, if the light-emitting source of the referring brightness-enhanced light-emitting structure is a blue light source, the aforesaid filling of inert gas is not required.

While the preferred embodiment of the invention has been set forth for the purpose of disclosure, modifications of the disclosed embodiment of the invention as well as other embodiments thereof may occur to those skilled in the art. Accordingly, the appended claims are intended to cover all embodiments which do not depart from the spirit and scope of the invention.

## Claims

1. A brightness-enhanced light-emitting structure of a luminescent assembly, comprising:
a blue/ultraviolet light-emitting source, being a bar-shaped tube, having a cover layer formed on a top portion of the circumference thereof; and
a light screen, being another bar-shaped tube disposed surrounding the bar-shaped light-emitting source, having a primary visible light layer formed at a portion of the
inner surface of the light screen at the position corresponding to a bottom portion of the circumference of the light-emitting source where is not covered by the cover layer;
wherein, the area of the primary visible light layer is larger than that of the light-emitting source; and the primary visible light layer is disposed a specific distance away from the cover layer of the light-emitting source for enabling the blue/ultraviolet light emitted from the light-emitting source to shine on the primary visible light layer sufficiently.

2. The brightness-enhanced light-emitting structure of claim 1, wherein the cover layer is formed on the top portion of the inner surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

3. The brightness-enhanced light-emitting structure of claim 2, wherein the cover layer is a light reflecting layer.

4. The brightness-enhanced light-emitting structure of claim 2, wherein the cover layer is a layer selected from the group consisting of a fluorescent coating and a phosphorescent coating.

5. The brightness-enhanced light-emitting structure of claim 4, wherein the cover layer further comprises:
a light reflecting layer, having a plurality of holes formed thereon, being formed superimposing the fluorescent/phosphorescent coating of the cover layer.

6. The brightness-enhanced light-emitting structure of claim 1, wherein the cover layer is formed on the top portion of the outer surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

7. The brightness-enhanced light-emitting structure of claim 6, wherein the cover layer is a light reflecting layer.

8. The brightness-enhanced light-emitting structure of claim 7, wherein the light reflecting layer has a plurality of holes formed thereon while each is filled with a material selected from the group consisting of a fluorescence material and a phosphorescence material.

9. The brightness-enhanced light-emitting structure of claim 6, wherein the cover layer is substantially a transparent cap with an inner surface coated with a layer selected from a fluorescent coating and a phosphorescent coating, capable of covering the blue/ultraviolet light-emitting source while enabling the inner surface thereof to face toward the blue/ultraviolet light-emitting source.

10. The brightness-enhanced light-emitting structure of claim 9, wherein the cover layer further comprises:
a light reflecting layer, having a plurality of holes formed thereon, being formed superimposing the fluorescent/phosphorescent coating of the cover layer.

11. The brightness-enhanced light-emitting structure of claim 6, wherein the cover layer is substantially a transparent cap with an inner surface coated with a light reflecting layer having a plurality of holes, where each hole being filled with a material elected from the group consisting of a fluorescence material and a phosphorescence material.

12. The brightness-enhanced light-emitting structure of claim 11, wherein the appearance of the luminescent assembly using the brightness-enhanced light-emitting structure is formed in a shape selected from the group consisting of a bar-shaped tube, a U-shaped tube, a circular tube, a planar spiral tube, a stereoscopic spiral tube, and a stereoscopic conical helix tube.

13. The brightness-enhanced light-emitting structure of claim 12, wherein the cross section of the blue/ultraviolet light-emitting source is in a shape selected from the group consisting of a circular, a semi-circular, a triangle, a rectangle and a polygon.

14. The brightness-enhanced light-emitting structure of claim 13, wherein the cross section of the light screen is a shape selected from the group consisting of a circular, a semi-circular, a triangle, a rectangle and a polygon.

15. The brightness-enhanced light-emitting structure of claim 14, wherein a cap, capable of absorbing ultraviolet light, is disposed on the outer circumference of the light screen.

16. The brightness-enhanced light-emitting structure of claim 15, wherein the blue/ultraviolet light-emitting source is made of a quartz glass substrate.

17. A brightness-enhanced light-emitting structure of a luminescent assembly, comprising:
at least a blue/ultraviolet light-emitting source, each being a bar-shaped tube, each
having a cover layer formed on a top portion of the circumference thereof; and
a light screen, being a box having an opening formed at the top thereof, having a primary visible light layer formed at the inner surfaces of the bottom and the sides of the box while enabling the at least one blue/ultraviolet light-emitting source to be positioned over the bottom thereof;
wherein, the area of the primary visible light layer is larger than overall area of the at least one light-emitting source; and the primary visible light layer is disposed a specific distance away from the cover layer of the at least one light-emitting source for enabling the blue/ultraviolet light emitted from the at least one light-emitting source to shine on the primary visible light layer sufficiently.

18. The brightness-enhanced light-emitting structure of claim 17, wherein the cover layer is formed on the top portion of the inner surface of each blue/ultraviolet light-emitting source, and the primary visible light layer is a layer selected from the group consisting of a fluorescent coating, a phosphorescent coating and a light reflecting layer having an inner surface coated with at least one of the aforesaid coatings.

19. The brightness-enhanced light-emitting structure of claim 18, wherein each cover layer is a light reflecting layer.

20. The brightness-enhanced light-emitting structure of claim 18, wherein each cover layer is a layer selected from the group consisting of a fluorescent coating and a phosphorescent coating.

21. The brightness-enhanced light-emitting structure of claim 20, wherein each cover layer further comprises:
a light reflecting layer, having a plurality of holes formed thereon, being formed superimposing the fluorescent/phosphorescent coating of the cover layer.

22. The brightness-enhanced light-emitting structure of claim 17, wherein each cover layer is formed on the top portion of the outer surface of the corresponding blue/ultraviolet light-emitting source, and the primary visible light layer is a layer selected from the group consisting of a fluorescent coating, a phosphorescent coating and a light reflecting layer having an inner surface coated with at least one of the aforesaid coatings.

23. The brightness-enhanced light-emitting structure of claim 22, wherein each cover layer is a light reflecting layer.

24. The brightness-enhanced light-emitting structure of claim 23, wherein the light reflecting layer has a plurality of holes formed thereon while each is filled with a material selected from the group consisting of a fluorescence material and a phosphorescence material.

25. The brightness-enhanced light-emitting structure of claim 22, wherein the cover layer is substantially a transparent cap with an inner surface coated with a layer selected from a fluorescent coating and a phosphorescent coating, capable of covering the blue/ultraviolet light-emitting source while enabling the inner surface thereof to face toward the blue/ultraviolet light-emitting source.

26. The brightness-enhanced light-emitting structure of claim 25, wherein the cover layer further comprises:
a light reflecting layer, having a plurality of holes formed thereon, being formed superimposing the fluorescent/phosphorescent coating of the cover layer.

27. The brightness-enhanced light-emitting structure of claim 22, wherein the cover layer is substantially a transparent cap with an inner surface coated with a light reflecting layer having a plurality of holes, where each hole being filled with a material elected from the group consisting of a fluorescence material and a phosphorescence material.

28. The brightness-enhanced light-emitting structure as recited in any of the claims 17-27, wherein the bottom of the transverse cross section of the light screen is in a shape selected from the group consisting of a straight line, a V-shape line, a jagged line, a single arc, a serial of interconnected arcs.

29. The brightness-enhanced light-emitting structure of claim 28, wherein the cross section of the blue/ultraviolet light-emitting source is in a shape selected from the group consisting of a circular, a semi-circular, a triangle, a rectangle and a polygon.

30. The brightness-enhanced light-emitting structure of claim 29, wherein the appearance of the blue/ultraviolet light-emitting source is formed in a shape selected from the group consisting of a bar-shaped tube, a U-shaped tube, a circular tube, a jagged tube.

31. The brightness-enhanced light-emitting structure of claim 30, wherein a cap, capable of absorbing ultraviolet light, is disposed on the outer circumference of the light screen.

32. The brightness-enhanced light-emitting structure of claim 31, wherein the blue/ultraviolet light-emitting source is made of a quartz glass substrate.

33. A brightness-enhanced light-emitting structure of a luminescent assembly, comprising:
at least a blue/ultraviolet light-emitting source, each being a bar-shaped tube;
a transparent cap, further comprising:
at least a recess, each formed at a bottom of the cap for enabling each to received one of the at least one blue/ultraviolet light-emitting source and each having a cover layer formed at an inner surface of a corresponding recess;
and
a light screen, being a box having an opening formed at the top thereof, having a
primary visible light layer formed at the inner surfaces of the bottom and the sides of
the box while enabling the at least one blue/ultraviolet light-emitting source to be
positioned over the bottom thereof;
wherein, the area of the primary visible light layer is larger than overall area of the at least one light-emitting source; and the primary visible light layer is disposed a specific distance away from the cover layer of the at least one light-emitting source for enabling the blue/ultraviolet light emitted from the at least one light-emitting source to shine on the primary visible light layer sufficiently.

34. The brightness-enhanced light-emitting structure of claim 33, wherein each cover layer is a light reflecting layer.

35. The brightness-enhanced light-emitting structure of claim 34, wherein the light reflecting layer has a plurality of holes formed thereon while each is filled with a material selected from the group consisting of a fluorescence material and a phosphorescence material.

36. The brightness-enhanced light-emitting structure of claim 33, wherein each cover layer is a layer selected from the group consisting of a fluorescent coating and a phosphorescent coating.

37. The brightness-enhanced light-emitting structure of claim 36, wherein the cover layer further comprises:
a light reflecting layer, having a plurality of holes formed thereon, being formed superimposing the fluorescent/phosphorescent coating of the cover layer.

38. The brightness-enhanced light-emitting structure of claim 33, wherein the cover layer is substantially a light reflecting layer having a plurality of holes formed thereon while enabling each hole to be filled with a material selected from the group consisting of a fluorescence material and a phosphorescence material.

39. The brightness-enhanced light-emitting structure as recited in any of the claims 33-38, wherein the primary visible light layer is a layer selected from the group consisting of a fluorescent coating, a phosphorescent coating and a light reflecting layer having an inner surface coated with at least one of the aforesaid coatings.

40. The brightness-enhanced light-emitting structure of claim 39, wherein the bottom of the transverse cross section of the light screen is in a shape selected from the group consisting of a straight line, a V-shape line, a jagged line, a single arc, a serial of interconnected arcs.

41. The brightness-enhanced light-emitting structure of claim 40, wherein the cross section of the blue/ultraviolet light-emitting source is in a shape selected from the group consisting of a circular, a semi-circular, a triangle, a rectangle and a polygon.

42. The brightness-enhanced light-emitting structure of claim 41, wherein the appearance of the blue/ultraviolet light-emitting source is formed in a shape selected from the group consisting of a bar-shaped tube, a U-shaped tube, a circular tube, a jagged tube.

43. The brightness-enhanced light-emitting structure of claim 42, wherein a cap, capable of absorbing ultraviolet light, is disposed on the outer circumference of the light screen.

44. The brightness-enhanced light-emitting structure of claim 43, wherein the blue/ultraviolet light-emitting source is made of a quartz glass substrate.

45. A brightness-enhanced light-emitting structure of a luminescent assembly, comprising:
a light-emitting source, being a bar-shaped tube capable of emitting ultraviolet light, having a cover layer formed on a top portion of the circumference thereof; and
a light screen, being substantially a solid transparent base, having a top surface capable of enabling the light-emitting source to fix thereupon and a bottom with a primary visible light layer formed thereon;
wherein, the area of the primary visible light layer is larger than that of the light-emitting source; and the primary visible light layer is disposed a specific distance away from the cover layer of the light-emitting source for enabling the ultraviolet light emitted from the light-emitting source to shine on the primary visible light layer sufficiently.

46. The brightness-enhanced light-emitting structure of claim 45, wherein the cover layer is formed on the top portion of the inner surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

47. The brightness-enhanced light-emitting structure of claim 46, wherein the cover layer is a light reflecting layer.

48. The brightness-enhanced light-emitting structure of claim 46, wherein the cover layer is a layer selected from the group consisting of a fluorescent coating and a phosphorescent coating.

49. The brightness-enhanced light-emitting structure of claim 48, wherein the cover layer further comprises
a light reflecting layer, having a plurality of holes formed thereon, being formed superimposing the fluorescent/phosphorescent coating of the cover layer.

50. The brightness-enhanced light-emitting structure of claim 45, wherein the cover layer is formed on the top portion of the outer surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

51. The brightness-enhanced light-emitting structure of claim 50, wherein the cover layer is a light reflecting layer.

52. The brightness-enhanced light-emitting structure of claim 50, wherein the cover layer is substantially a transparent cap with an inner surface coated with a layer selected from a fluorescent coating and a phosphorescent coating, capable of covering the blue/ultraviolet light-emitting source while enabling the inner surface thereof to face toward the blue/ultraviolet light-emitting source.

53. The brightness-enhanced light-emitting structure of claim 52, wherein the cover layer further comprises:
a light reflecting layer, having a plurality of holes formed thereon, being formed superimposing the fluorescent/phosphorescent coating of the cover layer.

54. The brightness-enhanced light-emitting structure as recited in any of the claims 45-53, wherein the outlook of the solid transparent base is in a shape selected from the group consisting of a semi-circular column, a triangle column, a rectangle column and a polygon column.

55. The brightness-enhanced light-emitting structure of claim 54, wherein the cross section of the light-emitting source is in a shape selected from the group consisting of a circular, a semi-circular, a triangle, a rectangle and a polygon.

56. The brightness-enhanced light-emitting structure of claim 55, wherein the light-emitting source and the solid transparent base are made of a quartz glass substrate.

57. The brightness-enhanced light-emitting structure of claim 56, wherein a cap, capable of absorbing ultraviolet light, is disposed on the outer circumference of the light-emitting source.

58. A brightness-enhanced light-emitting structure of a luminescent assembly, comprising:
a light-emitting source, being a bar-shaped tube capable of emitting ultraviolet light, having a cover layer formed on a top portion of the circumference thereof; and
a light screen, being substantially a hollow base, having a top surface capable of enabling the light-emitting source to fix thereupon and a bottom with a primary visible light layer formed thereon;
wherein, the area of the primary visible light layer is larger than that of the light-emitting source; and the primary visible light layer is disposed a specific distance away from the cover layer of the light-emitting source for enabling the ultraviolet light emitted from the light-emitting source to illuminate on the primary visible light layer sufficiently.

59. The brightness-enhanced light-emitting structure of claim 58, wherein the cover layer is formed on the top portion of the inner surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

60. The brightness-enhanced light-emitting structure of claim 59, wherein the cover layer is a light reflecting layer.

61. The brightness-enhanced light-emitting structure of claim 59, wherein the cover layer is a layer selected from the group consisting of a fluorescent coating and a phosphorescent coating.

62. The brightness-enhanced light-emitting structure of claim 61, wherein the cover layer further comprises:
a light reflecting layer, having a plurality of holes formed thereon, being formed superimposing the fluorescent/phosphorescent coating of the cover layer.

63. The brightness-enhanced light-emitting structure of claim 58, wherein the cover layer is formed on the top portion of the outer surface of the blue/ultraviolet light-emitting source, and the primary visible light layer is a layer selected from the group consisting of a fluorescent coating, a phosphorescent coating and a light reflecting layer having an inner surface coated with at least one of the aforesaid coatings.

64. The brightness-enhanced light-emitting structure of claim 63, wherein the cover layer is a light reflecting layer.

65. The brightness-enhanced light-emitting structure of claim 63, wherein the cover layer is substantially a transparent cap with an inner surface coated with a layer selected from a fluorescent coating and a phosphorescent coating, capable of covering the blue/ultraviolet light-emitting source while enabling the inner surface thereof to face toward the blue/ultraviolet light-emitting source.

66. The brightness-enhanced light-emitting structure of claim 58, wherein the cover layer further comprises:
a light reflecting layer, having a plurality of holes formed thereon, being formed superimposing the fluorescent/phosphorescent coating of the cover layer.

67. The brightness-enhanced light-emitting structure as recited in any one of the claims 58-66, wherein the outlook of the hollow base is in a shape selected from the group consisting of a semi-circular column, a triangle column, a rectangle column and a polygon column.

68. The brightness-enhanced light-emitting structure of claim 67, wherein the hollow base is made of a transparent substrate.

69. The brightness-enhanced light-emitting structure of claim 67, wherein the top surface of the hollow base is made of a transparent substrate.

70. The brightness-enhanced light-emitting structure of claim 67, wherein the cross section of the light-emitting source is in a shape selected from the group consisting of a circular, a semi-circular, a triangle, a rectangle and a polygon.

71. The brightness-enhanced light-emitting structure of claim 70, wherein the light-emitting source and the hollow base are made of a quartz glass substrate.

72. The brightness-enhanced light-emitting structure of claim 71, wherein a cap, capable of absorbing ultraviolet light, is disposed on the outer circumference of the light-emitting source.

73. A brightness-enhanced light-emitting structure of a luminescent assembly, comprising:
at least a light-emitting source, each being a bar-shaped tube capable of emitting a light selected from the group consisting of a ultraviolet light and a blue light, each having a cover layer formed on a top portion of the circumference thereof; and
at least a light screen, being substantially a plurality of interconnected concaved column bases, each concaved column base having a open area capable of enabling the corresponding light-emitting source to fix thereupon and an arc wall fro enabling a primary visible light layer to form thereon;
wherein, the area of the primary visible light layer is larger than that of the light-emitting source; and the primary visible light layer is disposed a specific distance away from the cover layer of the light-emitting source for enabling the ultraviolet/blue light emitted from the light-emitting source to shine on the primary visible light layer sufficiently.

74. The brightness-enhanced light-emitting structure of claim 73, wherein the cover layer is substantially a light reflecting layer having a plurality of holes formed thereon while enabling each hole to be filled with a material selected from the group consisting of a fluorescence material and a phosphorescence material.

75. The brightness-enhanced light-emitting structure of claim 73, wherein the cover layer further comprises:
a transparent cover sheet, coated with a layer selected from the group consisting of a fluorescent coating, for covering the at least one light-emitting source; and
a light reflecting layer with a plurality of hole formed thereon, being disposed underneath the transparent cover sheet.

76. The brightness-enhanced light-emitting structure as recited in any one of the claims 73-75, wherein a mask, made of a transparent material, is arranged at a side of the at least one light-emitting source.

77. The brightness-enhanced light-emitting structure of claim 76, wherein a cap, capable of absorbing ultraviolet light, is disposed on the outer circumference of the at least one light-emitting source.

78. A brightness-enhanced light-emitting structure of a luminescent assembly, comprising:
at least a light-emitting source, each composed of a pair of neighboring anode and cathode, each having a cover layer formed directly over the top of the at least one light-emitting source; and
a light screen, being substantially a top-opening hollow flat base, having a primary visible light layer formed on every inner sides of the hollow flat base while enabling the least one light-emitting source to be placed crossing over the top opening of the flat base; and
a sealing cap, for covering and sealing the top opening of the hollow flat base while enabling the light screen to be integrated into a sealed structure.

79. The brightness-enhanced light-emitting structure of claim 78, wherein the cover layer is formed at a position selected from the group consisting of a top surface of the sealing cap and a bottom surface of the sealing cap.

80. The brightness-enhanced light-emitting structure of claim 79, wherein the cover layer is a layer selected from the group consisting of a fluorescent coating, a phosphorescent coating, a light reflecting layer, the light reflecting layer having a plurality of holes formed thereon while each is filled with a material selected from the group consisting of a fluorescence material and a phosphorescence material.

81. The brightness-enhanced light-emitting structure of claim 80, wherein the primary visible light layer is a layer selected from the group consisting of a fluorescent coating and a phosphorescent coating.

82. The brightness-enhanced light-emitting structure as recited in any one of the claims 78-81, wherein a light reflecting layer is disposed at an outer surface of the light screen.

83. The brightness-enhanced light-emitting structure of claim 82, wherein the hollow of the light screen is filled by an inert gas.

84. The brightness-enhanced light-emitting structure of claim 78, wherein a insulating layer, made of a comparatively thinner quarts glass, is sandwiched between the at least one light-emitting source and the sealing cap.

85. The brightness-enhanced light-emitting structure of claim 84, wherein the cover layer is formed at a position selected from the group consisting of a top surface of the insulating layer and a bottom surface of the insulating layer.

86. The brightness-enhanced light-emitting structure of claim 85, wherein the cover layer is a layer selected from the group consisting of a fluorescent coating, a phosphorescent coating, a light reflecting layer, the light reflecting layer having a plurality of holes formed thereon while each is filled with a material selected from the group consisting of a fluorescence material and a phosphorescence material.

87. The brightness-enhanced light-emitting structure of claim 86, wherein the primary visible light layer is a layer selected from the group consisting of a fluorescent coating and a phosphorescent coating.

88. The brightness-enhanced light-emitting structure as recited in any one of the claims 84-87, wherein a light reflecting layer is disposed at an outer surface of the light screen.

89. The brightness-enhanced light-emitting structure of claim 88, wherein the hollow of the light screen is filled by an inert gas.

90. A brightness-enhanced light-emitting structure of a luminescent assembly, comprising:
at least a light-emitting source, each being substantially a light emitting diode (LED) capable of emitting ultraviolet (UV) light; and
a light screen, being substantially a top-opening hollow box-like base, having a primary visible light layer formed on every inner sides and a bottom of the hollow box-like base while enabling the least one light-emitting source to be arranged on the bottom thereof;
wherein, the area of the primary visible light layer is obviously larger than that of the at least one light-emitting source; and a bottom of the primary visible light layer is spaced from the at least one light-emitting source by a specific distance for enabling the downward-irradiating UV light of the at least one light-emitting source to shine on the corresponding portion of the primary visible light layer and thus exciting visible light therefrom.

91. The brightness-enhanced light-emitting structure of claim 90, wherein the light emitting diode (LED) is an LED chip having a cover layer, composed of a light reflecting layer, arranged at the top thereof.

92. The brightness-enhanced light-emitting structure of claim 91, wherein the LED chip is fixedly arranged at a position of a bottom surface of a first electrode plate, being slightly larger than the LED chip, while connecting the anode and the cathode of the LED chip by bonding wires respectively to the first electrode plate and a second electrode plate.

93. The brightness-enhanced light-emitting structure of claim 92, wherein the second electrode plate is arranged to overlay the first electrode plate while sandwiching an insulating layer therebetween.

94. The brightness-enhanced light-emitting structure of claim 92, wherein the cover layer is structured as one of the following: being arranged directly at the bottom surface of the first electrode plate, and being integrated formed with the LED chip.

95. The brightness-enhanced light-emitting structure of claim 90, wherein the LED is a device selected from the group consisting of a surface-mount-device (SMD) LED and a lamp-type LED.

96. The brightness-enhanced light-emitting structure as recited in any one of the claims 90-95, wherein the top-opening hollow base is a base selected from the group consisting of a box-like base of any shape, a semi-sphere base, a semi-column base, a rectangular base, a trapezoid base, a polygonal base, a W-shaped base, a semi-sphere transparent base, a semi-column transparent base, a rectangular transparent base, a trapezoid transparent base, a polygonal transparent base, and a W-shaped transparent base.

97. The brightness-enhanced light-emitting structure of claim 96, wherein the primary visible light layer is a layer selected from the group consisting of a fluorescent coating, a phosphorescent coating and a light reflecting layer having an inner surface coated with at least one of the aforesaid coatings.

98. The brightness-enhanced light-emitting structure of claim 97, wherein an ultraviolet-absorbing cap is disposed at a position covering the top opening of the light screen.

99. The brightness-enhanced light-emitting structure of claim 98, wherein the ultraviolet-absorbing cap is substantially a transparent ultraviolet-absorbing cap with arc-shaped head.

100. The brightness-enhanced light-emitting structure of claim 97, wherein a light reflecting layer is formed at the outside of the primary visible light layer.

101. The brightness-enhanced light-emitting structure of claim 100, wherein an ultraviolet-absorbing cap is disposed at a position covering the top opening of the light screen.

102. The brightness-enhanced light-emitting structure of claim 101, wherein the ultraviolet-absorbing cap is substantially a transparent ultraviolet-absorbing cap with arc-shaped head.

103. The brightness-enhanced light-emitting structure of claim 96, wherein the a light emitting diode capable of emitting ultraviolet light is replaced and substituted by another emitting diode capable of emitting blue light.

104. The brightness-enhanced light-emitting structure of claim 103, wherein the primary visible light layer is a layer selected from the group consisting of a fluorescent coating, a phosphorescent coating and a light reflecting layer having an inner surface coated with at least one of the aforesaid coatings.

105. The brightness-enhanced light-emitting structure of claim 104, wherein the hollow portion of the light screen is filled by a filling material for integrating the light screen with the light-emitting source.

106. The brightness-enhanced light-emitting structure of claim 104, wherein a light reflecting layer is formed at the outside of the primary visible light layer.

107. The brightness-enhanced light-emitting structure of claim 106, wherein the hollow portion of the light screen is filled by a filling material for integrating the light screen with the light-emitting source.

108. The brightness-enhanced light-emitting structure of claim 103, wherein a plurality of holes are formed on the primary visible light layer.

109. The brightness-enhanced light-emitting structure of claim 108, wherein the hollow portion of the light screen is filled by a filling material for integrating the light screen with the light-emitting source.

110. The brightness-enhanced light-emitting structure of claim 108, wherein a light reflecting layer is formed at the outside of the primary visible light layer.

111. The brightness-enhanced light-emitting structure of claim 110, wherein the hollow portion of the light screen is filled by a filling material for integrating the light screen with the light-emitting source.

112. A brightness-enhanced light-emitting structure of a luminescent assembly, comprising:
at least a light-emitting source, electrically connected to a first and a second electrode plates, each being substantially a blue light LED having a cover layer, composed of a light reflecting layer, arranged at the top thereof; and
a light screen, being substantially a top-opening hollow base;
wherein the top-opening hollow base is received in a central concave of a transparent block while a primary visible light layer, composed of a fluorescent/phosphorescent coating, is formed on every inner walls of the central concave; the at least one light-emitting source is arranged over the bottom of the concave while being sealed therein by a transparent filling material; and the area of the primary visible light layer is obviously larger than that of the at least one light-emitting source while a bottom of the primary visible light layer is spaced from the at least one light-emitting source by a specific distance for enabling the downward-irradiating blue light of the at least one light-emitting source to shine on the corresponding portion of the primary visible light layer and thus exciting visible light therefrom.

113. The brightness-enhanced light-emitting structure of claim 112, wherein the cover layer is structured as one of the following: being arranged directly at the bottom surface of the first electrode plate, and being integrated formed with the LED.

114. The brightness-enhanced light-emitting structure as recited in any one of the claims 112-113, wherein the top-opening hollow base is a base selected from the group consisting of a box-like base of any shape, a semi-sphere base, a semi-column base, a rectangular base, a trapezoid base, a polygonal base, a W-shaped base, a semi-sphere transparent base, a semi-column transparent base, a rectangular transparent base, a trapezoid transparent base, a polygonal transparent base, and a W-shaped transparent base.

115. The brightness-enhanced light-emitting structure of claim 114, wherein a light reflecting layer is formed at the outer side walls of the light screen.

116. A brightness-enhanced light-emitting structure of a luminescent assembly, comprising:
at least a light-emitting source, electrically connected to a first and a second electrode plates, each being substantially a blue light LED having a cover layer, composed of a light reflecting layer, arranged at the top thereof; and
a light screen, being substantially a top-opening hollow base, having a primary visible light layer coated in the hollow thereof by a specific thickness while the primary visible light layer is made of a mixture of a resin and a fluorescence/phosphorescence material;
wherein, the at least one light-emitting source is arranged over primary visible light layer while being sealed in the hollow base by a transparent filling material; and the area of the primary visible light layer is obviously larger than that of the at least one light-emitting source while primary visible light layer is spaced from the at least one light-emitting source by a specific distance for enabling the downward-irradiating blue light of the at least one light-emitting source to shine on the corresponding portion of the primary visible light layer and thus exciting visible light therefrom.

117. The brightness-enhanced light-emitting structure of claim 116, wherein the transparent filling material is replaced and substituted by the mixture of the resin and the fluorescence/phosphorescence material, the same as that used for forming the primary visible light layer.

118. The brightness-enhanced light-emitting structure as recited in any one of the claims 116-117, wherein the cover layer is structured as one of the following: being arranged directly at the bottom surface of the first electrode plate, and being integrated formed with the blue light LED.

119. The brightness-enhanced light-emitting structure of claim 118, wherein the top-opening hollow base is a base selected from the group consisting of a box-like base of any shape, a semi-sphere base, a semi-column base, a rectangular base, a trapezoid base, a polygonal base, a W-shaped base, a semi-sphere transparent base, a semi-column transparent base, a rectangular transparent base, a trapezoid transparent base, a polygonal transparent base, and a W-shaped transparent base.

120. A brightness-enhanced light-emitting structure of a luminescent assembly, comprising:
at least a light-emitting source, each being substantially a ultraviolet light LED having a cover layer, composed of a light reflecting layer, arranged at the top thereof; and
a light screen, providing a top surface thereof for securing each bottom of the at least one light-emitting source thereon while having its bottom circumference to be coated by a primary visible light layer;
wherein, the area of the primary visible light layer is obviously larger than that of the at least one light-emitting source while primary visible light layer is spaced from the at least one light-emitting source by a specific distance for enabling the downward-irradiating UV light of the at least one light-emitting source to shine on the corresponding portion of the primary visible light layer and thus exciting visible light therefrom.

121. The brightness-enhanced light-emitting structure of claim 120, wherein the ultraviolet light LED is a LED chip capable of emitting ultraviolet light.

122. The brightness-enhanced light-emitting structure of claim 120, wherein the cover layer is integrated formed with the LED chip.

123. The brightness-enhanced light-emitting structure of claim 120, wherein the light screen is formed in a shape selected from the group consisting of a transparent semi-sphere solid base, a transparent semi-column solid base, a transparent rectangular solid base, a transparent trapezoid solid base, a transparent polygonal solid base, a transparent semi-sphere hollow base, a transparent semi-column hollow base, a transparent rectangular hollow base, a transparent trapezoid hollow base, a transparent polygonal hollow base

124. The brightness-enhanced light-emitting structure of claim 123, wherein the primary visible light layer is a layer selected from the group consisting of a fluorescent coating and a phosphorescent coating.

125. The brightness-enhanced light-emitting structure of claim 124, wherein a transparent ultraviolet-absorbing cap is disposed surrounding the outer circumference of the luminescent assembly.

126. The brightness-enhanced light-emitting structure of claim 124, wherein a light reflecting layer is formed at the outside of the primary visible light layer.

127. The brightness-enhanced light-emitting structure of claim 126, wherein a transparent ultraviolet-absorbing cap is disposed surrounding the outer circumference of the luminescent assembly.

128. The brightness-enhanced light-emitting structure of claim 123, wherein the cover layer is replaced and substituted by a layer selected from the group consisting of a fluorescent coating and a phosphorescent coating, while the primary visible light layer is a layer selected from the group consisting of a fluorescent coating and a phosphorescent coating.

129. The brightness-enhanced light-emitting structure of claim 128, wherein a transparent ultraviolet-absorbing cap is disposed surrounding the outer circumference of the luminescent assembly.

130. The brightness-enhanced light-emitting structure of claim 128, wherein a light reflecting layer is formed at the outside of the primary visible light layer.

131. The brightness-enhanced light-emitting structure of claim 130, wherein a transparent ultraviolet-absorbing cap is disposed surrounding the outer circumference of the luminescent assembly.

132. The brightness-enhanced light-emitting structure of claim 123, wherein the ultraviolet light LED is replaced and substituted by a blue light LED.

133. The brightness-enhanced light-emitting structure of claim 132, wherein the primary visible light layer is a layer selected from the group consisting of a fluorescent coating, a phosphorescent coating and a light reflecting layer having an inner surface coated with at least one of the aforesaid coatings.

134. The brightness-enhanced light-emitting structure of claim 133, wherein a light reflecting layer is formed at the outside of the primary visible light layer.

135. The brightness-enhanced light-emitting structure of claim 132, wherein the cover layer is a layer selected from the group consisting of a fluorescent coating, a phosphorescent coating and a light reflecting layer having an inner surface coated with at least one of the aforesaid coatings.

136. The brightness-enhanced light-emitting structure of claim 135, wherein a light reflecting layer is formed at the outside of the primary visible light layer.

137. The brightness-enhanced light-emitting structure of claim 132, wherein a plurality of holes are formed on the primary visible light layer.

138. The brightness-enhanced light-emitting structure of claim 123, wherein the cover layer, composed of the light reflecting layer, is substantially a cup-like cap covering on top of the at least one light-emitting source.

139. The brightness-enhanced light-emitting structure of claim 138, wherein the primary visible light layer is a layer selected from the group consisting of a fluorescent coating, a phosphorescent coating and a light reflecting layer having an inner surface coated with at least one of the aforesaid coatings.

140. The brightness-enhanced light-emitting structure of claim 140, wherein a light reflecting layer is formed at the outside of the primary visible light layer.

141. The brightness-enhanced light-emitting structure of claim 140, wherein a transparent ultraviolet-absorbing cap is disposed surrounding the outer circumference of the luminescent assembly.

142. The brightness-enhanced light-emitting structure of claim 138, wherein a plurality of holes is formed on the cup-like cap, while each hole is filled with one material selected from the group consisting of a fluorescence material and a phosphorescence material.

143. The brightness-enhanced light-emitting structure of claim 142, wherein the primary visible light layer is a layer selected from the group consisting of a fluorescent coating, a phosphorescent coating and a light reflecting layer having an inner surface coated with at least one of the aforesaid coatings.

144. The brightness-enhanced light-emitting structure of claim 143, wherein a light reflecting layer is formed at the outside of the primary visible light layer.

145. The brightness-enhanced light-emitting structure of claim 144, wherein a transparent ultraviolet-absorbing cap is disposed surrounding the outer circumference of the luminescent assembly.

146. The brightness-enhanced light-emitting structure of claim 138, wherein the ultraviolet light LED is replaced and substituted by a blue light LED.

147. The brightness-enhanced light-emitting structure of claim 146, wherein the primary visible light layer is a layer selected from the group consisting of a fluorescent coating, a phosphorescent coating and a light reflecting layer having an inner surface coated with at least one of the aforesaid coatings.

148. The brightness-enhanced light-emitting structure of claim 147, wherein a light reflecting layer is formed at the outside of the primary visible light layer.

149. The brightness-enhanced light-emitting structure of claim 142, wherein the ultraviolet light LED is replaced and substituted by a blue light LED.

150. The brightness-enhanced light-emitting structure of claim 149, wherein the primary visible light layer is a layer selected from the group consisting of a fluorescent coating, a phosphorescent coating and a light reflecting layer having an inner surface coated with at least one of the aforesaid coatings.

151. The brightness-enhanced light-emitting structure of claim 150, wherein a light reflecting layer is formed at the outside of the primary visible light layer.

152. A brightness-enhanced light-emitting structure of a luminescent assembly, comprising:
a light screen, being substantially a top-opening hollow base, having a primary visible light layer coated on its bottom circumference;
a transparent ultraviolet-absorbing cap, disposed surrounding the outer circumference of the luminescent assembly; and
at least a light-emitting source, each being substantially an LED capable emitting ultraviolet/blue light, each being secured to the bottom of the ultraviolet-absorbing cap;
wherein, the area of the primary visible light layer is obviously larger than that of the at least one light-emitting source while primary visible light layer is spaced from the at least one light-emitting source by a specific distance for enabling the downward-irradiating ultraviolet/blue light of the at least one light-emitting source to shine on the corresponding portion of the primary visible light layer and thus exciting visible light therefrom.

153. The brightness-enhanced light-emitting structure of claim 152, wherein the LED is a device selected from the group consisting of a surface-mount-device (SMD) LED and a lamp-type LED.

154. The brightness-enhanced light-emitting structure of claim 152, wherein the light emitting diode (LED) is an LED chip having a cover layer, composed of a light reflecting layer, arranged at the top thereof.

155. The brightness-enhanced light-emitting structure of claim 154, wherein the cover layer is integrated formed with the LED chip.

156. The brightness-enhanced light-emitting structure of claim 154, wherein the light reflecting layer is a layer selected from the group consisting of a fluorescent coating, a phosphorescent coating and a light reflecting layer having an inner surface coated with at least one of the aforesaid coatings.

157. The brightness-enhanced light-emitting structure as recited in any one of the claims 152-156, wherein the top-opening hollow base is a base selected from the group consisting of a box-like base of any shape, a semi-sphere base, a semi-column base, a rectangular base, a trapezoid base, a polygonal base, a W-shaped base, a semi-sphere transparent base, a semi-column transparent base, a rectangular transparent base, a trapezoid transparent base, a polygonal transparent base, and a W-shaped transparent base.

158. The brightness-enhanced light-emitting structure of claim 157, wherein the primary visible light layer is a layer selected from the group consisting of a fluorescent coating, a phosphorescent coating and a light reflecting layer having an inner surface coated with at least one of the aforesaid coatings.

159. The brightness-enhanced light-emitting structure of claim 158, wherein a light reflecting layer is formed at the outside of the primary visible light layer.

160. The brightness-enhanced light-emitting structure of claim 140, wherein, as each light-emitting source is a blue light LED, the hollow of the light screen is sealed by a filling material for integrating light screen with each light-emitting source.

161. The brightness-enhanced light-emitting structure of claim 160, wherein a plurality of holes are formed on the primary visible light layer.

162. A brightness-enhanced light-emitting structure of a luminescent assembly, comprising:
a light-emitting source, being substantially a blue light LED chip having a cover layer, composed of a light reflecting layer, arranged at the top thereof; and
a light screen, being substantially a bowl-like base having a primary visible light layer coated on its bottom circumference and a transparent supporter provided for the light-emitting source to disposed thereon;
wherein, the area of the primary visible light layer is obviously larger than that of the at least one light-emitting source while primary visible light layer is spaced from the at least one light-emitting source by a specific distance for enabling the downward-irradiating blue light of the at least one light-emitting source to shine on the corresponding portion of the primary visible light layer and thus exciting visible light therefrom.

163. The brightness-enhanced light-emitting structure of claim 162, wherein the cover layer is integrated formed with the LED chip.

164. The brightness-enhanced light-emitting structure as recited in any one of the claims 162-163, wherein the primary visible light layer is a layer selected from the group consisting of a fluorescent coating, a phosphorescent coating and a light reflecting layer having an inner surface coated with at least one of the aforesaid coatings.

165. The brightness-enhanced light-emitting structure of claim 164, wherein a plurality of holes are formed on the primary visible light layer.
